# EUROPEAN PATENT APPLICATION

(11) **EP 4 836 652 A1**
(43) Date of publication of application: **04.11.2026**
(21) Application number: 26169997.9
(22) Date of filing: 31.03.2026
(51) Int. Cl.: H10K 59/128, H10K 59/121

(54) **DISPLAY DEVICE AND AUTOMOBILE**

(30) Priority: 30.04.2025 KR 20250057101
(71) Applicant: Samsung Display Co., Ltd., Yongin-si, Gyeonggi-do 17113 (KR)
(72) Inventor: Choi, Nak Cho, Yongin-si, Gyeonggi-do (KR); Jang, Kyung Soo, Yongin-si, Gyeonggi-do (KR)
(74) Representative: Gulde & Partner

(57) **Abstract**

A display device is provided that includes, a pixel defining film including first and second openings partitioning first and second emission areas (EA1, EA4), first and second light emitting elements (170_1a, 170_1b) located in respective first and second openings, and a light control layer (LCL) including first and second light blocking layers (LS_L1, LS_L2) and a first light transmitting film (LT_L1). The first light blocking layer (LS_L1) comprises first and second sub-openings (OPT_L1, OPT_R1) corresponding to first and second openings (OPA_L, OPA,_R). The second light blocking layer (LS_L2) comprises third and fourth sub-openings (OPT_L2, OPT_R2) corresponding to first and second openings (OPA_L, OPA_ R). The first opening (OPA_L), first sub-opening (OPT_L1), and third sub-opening (OPT_L2) are arranged after each other in a direction inclined with respect to a thickness direction of the substrate, and the second opening (OPA_R), second sub-opening (OPT_R1), and fourth sub-opening (OPT_R2) are arranged after each other in another direction with respect to the thickness direction.

## Description

### TECHNICAL FIELD

The present disclosure relates to a display device, and an automobile that includes the display device. More particularly, the present disclosure relates to a display device that may provide different images to one side and another side of the display device, and an automobile that includes such a display device.

### BACKGROUND

With the advance of information-oriented society, more and more demands are placed on display devices for displaying images in various ways. The display device may be a display device such as a liquid crystal display, a field emission display and a light emitting display. The light emitting display may include an organic light emitting display device including an organic light emitting diode as a light emitting element or an inorganic light emitting display device including an inorganic light emitting diode as a light emitting element.

In the case of a vehicle display device, when the image displayed on the vehicle display device located in front of the driver or passenger is reflected on the windshield at night, it may interfere with the driver's driving.

Accordingly, there is a need to control viewing angles of images displayed on a display device of a vehicle.

### BRIEF SUMMARY

The disclosure is intended to solve problems including displaying of image for different viewers in a vehicle. The present disclosure describes a display device capable of providing different images to different sides of the display device and an automobile that includes the contemplated display device.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

The invention is defined by the appended set of claims. The description that follows is subjected to this limitation. Any disclosure lying outside the scope of said claims is only intended for illustrative as well as comparative purposes.

According to an aspect of the present disclosure, a display device includes, a first emission area and a second (or fourth, EA4 in the figures) emission area, a substrate, a circuit layer located on the substrate, an element layer located on the circuit layer, and including a pixel defining film including a first opening partitioning the first emission area and a second opening partitioning the second (or fourth, EA4 in the figures) emission area, a first light emitting element located in the first opening, and a second (or fourth, 170_1b in the figures) light emitting element located in the second opening, and a light control layer located on the element layer, and including a first light blocking layer, a first light transmitting film, and a second light blocking layer, wherein the first light blocking layer includes a first sub-opening corresponding or assigned to or associated with the first opening, and a second sub-opening corresponding or assigned to or associated with the second opening, the second light blocking layer includes a third sub-opening corresponding or assigned to or associated with the first opening, and a fourth sub-opening corresponding or assigned to or associated with the second opening, the first opening, the first sub-opening, and the third sub-opening are arranged side by side or one after the other in a direction inclined with respect to, e.g. toward or away from, a thickness direction of the substrate, and the second opening, the second sub-opening, and the fourth sub-opening are arranged side by side or one after the other in another direction inclined differently than the direction with respect to, e.g. away from or toward, the thickness direction. Hence, due to the different inclinations, the different emission areas can be seen from the different directions. The thickness direction may extend through a plane, e.g. a first plate, which may be a virtual plane. The plane may be arranged perpendicular to the substrate. The plane may be arranged between the light emitting elements. The plane may be defined, formed or spanned by the thickness direction and another direction, e.g. a second direction DR2 in the figures, that may extend perpendicular to the thickness direction. The direction and the other direction may be inclined away from the plane when the directions point away from the substrate through the openings and the sub-openings that correspond or are assigned to or are associated with each other. The direction may be inclined away from one side of the plane, and the other direction may be inclined away from the other side of the plane. The direction may be inclined towards a side of the display device, e.g. a lateral side thereof that may extend along the thickness direction. The other direction may be inclined towards another side of the display device, e.g. a lateral side thereof that may be opposite to the side and may extend along the thickness direction. The direction and the other direction may divert, e.g. from each other and/or from the thickness direction and/or from the plane. The direction may be designated as first inclined direction and the other direction may be designates as second inclined direction.

According to an embodiment, a first straight line connecting a center of the first sub-opening to a center of the third sub-opening is inclined toward or away from the first side. According to an embodiment, a second straight line connecting a center of the second sub-opening to a center of the fourth sub-opening is inclined toward or away from the second side. An advantage of this may be that more light can be directed into the two directions, as most of the light is emitted via the center.

According to an embodiment, an absolute value of an inclination of the first straight line with respect to the first direction or the thickness direction is equal to an absolute value of an inclination of the second straight line with respect to the first direction or the thickness direction. An advantage of this may be that the same brightness is available in the two directions.

According to an embodiment, a third straight line connecting an end or edge section of the first sub-opening to an end or edge section of the third sub-opening is inclined toward or away from the first side. According to an embodiment, a fourth (or a fifth in the figures) straight line connecting an end or edge section of the second sub-opening to an end or edge section of the fourth sub-opening is inclined toward or away from the second side. An advantage of this may be that the light emitted is well defines by the edges or ends.

According to an embodiment, an absolute value of an inclination of the third straight line with respect to the first direction or the thickness direction is equal to an absolute value of an inclination of the fourth or fifth straight line with respect to the first direction or the thickness direction. An advantage of this may be that the same brightness is available in the two directions.

According to an embodiment, a fifth (or a fourth in the figures) straight line connecting the other end or the opposite edge section of the first sub-opening to the other end or the opposite edge section of the third sub-opening is inclined toward or away from the first side. According to an embodiment, a sixth straight line connecting the other end or the opposite edge section of the second sub-opening to the other end or the opposite edge section of the fourth sub-opening is inclined toward or away from the second side. An advantage of this may be that the light emitted is well defines by the edges or ends.

According to an embodiment, an absolute value of an inclination of the fifth or fourth straight line with respect to the first direction or the thickness direction is equal to an absolute value of an inclination of the sixth straight line with respect to the first direction or the thickness direction. An advantage of this may be that the same brightness is available in the two directions.

According to an embodiment, an inclination of the first straight line with respect to the first direction or the thickness direction is smaller than an inclination of the third straight line with respect to the first direction or the thickness direction, and may be greater than an inclination of the fifth or the fourth straight line with respect to the first direction or the thickness direction. An advantage of this may be that undesired shadowing or directing is avoided.

According to an embodiment, a width of the first sub-opening is greater than a width of the third sub-opening. According to an embodiment, a width of the second sub-opening is greater than a width of the fourth sub-opening. An advantage of this may be that light can be emitted in a more directed manner.

According to an embodiment, the width of the first sub-opening and the width of the second sub-opening are equal to each other. According to an embodiment, the width of the third sub-opening and the width of the fourth sub-opening are equal to each other. An advantage of this may be that the same brightness is available in the two directions.

According to an embodiment, each of the first light blocking layer and the second light blocking layer comprises, a central light blocking film located between the first emission area and the second or fourth emission area, a first peripheral light blocking film located on the first side of the first emission area, and a second peripheral light blocking film located on the second side of the second or fourth emission area. According to an embodiment, the first peripheral light blocking film, the first emission area, the central light blocking film, the second or fourth emission area, and the second peripheral light blocking film are sequentially arranged along one direction or perpendicular to the thickness direction. An advantage of this may be that undesired shifting of parts of an image in the first or thickness direction are avoided.

According to an embodiment, the central light blocking film of each of the first light blocking layer and the second light blocking layer at least partially overlaps the first emission area and the second or fourth emission area. According to an embodiment, the first peripheral light blocking film and the second peripheral light blocking film of each of the first light blocking layer and the second light blocking layer do not overlap the first emission area and the second or fourth emission area. An advantage of this may be that in the respective direction, e.g. along the straight lines, undesired shadowing is avoided.

According to an embodiment, the display device comprises a second emission area with the second or fourth emission area between the first emission area and the second emission area in a direction crossing the thickness direction. According to an embodiment, the display device may further comprise a third emission area. According to an embodiment, the pixel defining film further comprises a third opening partitioning the third emission area. According to an embodiment, the element layer further comprises a third light emitting element located in the third opening. According to an embodiment, the first light blocking layer further comprises a fifth sub-opening corresponding to the third opening. According to an embodiment, the second light blocking layer further comprises a sixth sub-opening corresponding to the third opening. According to an embodiment, the third opening, the fifth sub-opening, and the sixth sub-opening are arranged side by side in a direction inclined toward the first side with respect to the first direction. An advantage of this may be that different light, e.g. light with different primary or fundamental colors like red, green, blue and magenta or even white light can be emitted in the respective inclined direction to form a color image.

According to an embodiment, the first emission area, the second or fourth emission area, and the second emission area are sequentially arranged side by side in a second direction crossing the first direction or a first direction crossing the thickness direction. An advantage of this may be that creating a color image is facilitated.

According to an embodiment, the first emission area and the third or the second emission area are arranged side by side in a first or a second direction crossing the first direction or the thickness direction. According to an embodiment, the first emission area and the second or fourth emission area are arranged side by side or extend in a third direction crossing the first direction and the second direction or in a second direction crossing the thickness direction and the first direction. An advantage of this may be that different pixel images can be formed easily in different directions

According to an embodiment, the light control layer further comprises an optical layer located above the first light blocking layer or the second light blocking layer. According to an embodiment, the optical layer comprises a first optical pattern overlapping the first sub-opening and the third sub-opening, and a second optical pattern overlapping the second sub-opening and the fourth sub-opening, and the first optical pattern and the second optical pattern may each comprise a condensing lens. An advantage of this may be that brightness loss can be further avoided, e.g. in a head box where a person's head is expected to be when viewing the display device, i.e. images or content displayed thereon.

According to an embodiment, the first optical pattern and the second optical pattern are convex in a direction opposite to a direction toward the substrate or the thickness direction. An advantage of this may be that more light can be emitted towards a person viewing the display device, i.e. images or content displayed thereon.

According to an embodiment, a width of the first optical pattern is greater than a width of the first sub-opening. According to an embodiment, a width of the third sub-opening, and a width of the second optical pattern is greater than a width of the second sub-opening and a width of the fourth sub-opening. An advantage of this may be that the respective optical pattern can be mounted easily without creating undesired shadowing.

According to another aspect of the present disclosure, an automobile is provided, the automobile including, a vehicle body, an interior space defined by the vehicle body, a dashboard located within the interior space, and a display device located on the dashboard, wherein the display device includes, a first emission area and a second or fourth emission area, a substrate, a circuit layer located on the substrate, an element layer located on the circuit layer, and including a pixel defining film including a first opening partitioning the first emission area and a second opening partitioning the second or fourth emission area, a first light emitting element located in the first opening, and a second (or fourth in the figures) light emitting element located in the second opening, and a light control layer located on the element layer, and including a first light blocking layer, a first light transmitting film, and a second light blocking layer, wherein the first light blocking layer includes a first sub-opening corresponding or assigned to or associated with the first opening, and a second sub-opening corresponding or assigned to or associated with the second opening, the second light blocking layer includes a third sub-opening corresponding or assigned to or associated with the first opening, and a fourth sub-opening corresponding or assigned to or associated with the second opening, the first opening, the first sub-opening, and the third sub-opening are arranged side by side or one after the other in a direction inclined toward or away from a thickness direction of the substrate, and the second opening, the second sub-opening, and the fourth sub-opening are arranged side by side or one after the other in another direction inclined toward or away from the thickness direction. Hence, due to the different inclinations, the different emission areas can be seen from the different directions, from which different occupants of the automobile view the display device. The thickness direction may extend through a plane, e.g. a first plate, which may be a virtual plane. The plane may be arranged perpendicular to the substrate. The plane may be arranged between the light emitting elements. The plane may be defined, formed or spanned by the thickness direction and another direction, e.g. a second direction DR2 in the figures, that may extend perpendicular to the thickness direction. The direction and the other direction may be inclined away from the plane when the directions point away from the substrate through the openings and the sub-openings that correspond or are assigned to or are associated with each other. The direction may be inclined away from one side of the plane, and the other direction may be inclined away from the other side of the plane. The direction may be inclined towards a side of the display device, e.g. a lateral side thereof that may extend along the thickness direction. The other direction may be inclined towards another side of the display device, e.g. a lateral side thereof that may be opposite to the side and may extend along the thickness direction. The direction and the other direction may divert, e.g. from each other and/or from the thickness direction and/or from the plane. The other direction may differ from the direction.

According to an embodiment, the automobile may further comprise a driver's seat and a passenger seat located within the interior space, wherein the dashboard comprises a first part located in front of the driver's seat, a second part located in front of the passenger seat, and a third part located between the first part and the second part, and the display device is located in the third part. An advantage of this may be that different contents can be shown to the driver and to the passenger. E.g. the driver can be shown diving related content, e.g. a map or a status of the automobile or a user interface, and the passenger can enjoy the same of different content, e.g. can read information from or view a movie on the display device.

Hence, different images may be displayed on the first side and the second side of the display device of the automobile of the present disclosure. It is noted that the terms "automobile" and "vehicle" are used in the present disclosure interchangeably.

Benefits of the display device of the present disclosure are not limited to the aforementioned, and various other effects are described in the detailed description below.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view showing a display device according to one embodiment of the present disclosure;
FIG. 2 is a plan view illustrating a display device according to one embodiment of the present disclosure;
FIG. 3 is a schematic cross-sectional view of the display device taken along line X1-X1' of FIG. 2;
FIG. 4 is a cross-sectional view illustrating an example of a display panel according to one embodiment of the present disclosure;
FIG. 5 is a schematic diagram when a display device is applied to a vehicle according to one embodiment of the present disclosure;
FIG. 6 is a schematic diagram illustrating how a display device displays an image according to one embodiment of the present disclosure;
FIG. 7 is a plan view illustrating the planar arrangement of an emission area and a light control layer of a display device according to one embodiment of the present disclosure;
FIG. 8 is a schematic diagram illustrating the planar arrangement of the emission area and the light control layer of the display device divided into layers according to one embodiment of the present disclosure;
FIG. 9 is a cross-sectional view taken along line X2-X2' of FIG. 7;
FIG. 10 is a simulation photograph showing a movement path of light in the display device according to one embodiment of the present disclosure;
FIG. 11 is a radial light intensity distribution diagram illustrating the light emission pattern of the first light emitting element group located in the first group area;
FIG. 12 is a radial light intensity distribution diagram illustrating the light emission pattern of the second light emitting element group located in the second group area;
FIG. 13 is a graph illustrating the light intensity by color according to the viewing angle;
FIG. 14 is a schematic diagram illustrating the planar arrangement of an emission area and a light control layer of a display device divided into layers according to another embodiment of the present disclosure;
FIG. 15 is a cross-sectional view taken along line X3-X3' of FIG. 14;
FIG. 16 is a cross-sectional view taken along line X4-X4' of FIG. 14;
FIG. 17 is a cross-sectional view taken along line X5-X5' of FIG. 14;
FIG. 18 is a plan view illustrating the planar arrangement of an emission area and a light control layer of a display device according to still another embodiment of the present disclosure;
FIG. 19 is a simulation photograph illustrating the movement path of light in a cross-section taken along line X6-X6' of FIG. 18;
FIG. 20 is a cross-sectional view showing a cross-section of a display device according to still another embodiment of the present disclosure;
FIG. 21 is a simulation photograph illustrating the movement path of light in a horizontal split display device among the display devices according to the embodiment of FIG. 20;
FIG. 22 is a simulation photograph illustrating the movement path of light in a vertical split display device among the display devices according to the embodiment of FIG. 20;
FIG. 23 is a block diagram of an electronic device according to one embodiment of the present disclosure; and
FIG. 24 is schematic views of electronic devices according to various embodiments of the present disclosure.

### DETAILED DESCRIPTION OF THE EMBODIMENTS

While specific embodiments are shown in the drawings and described in detail herein below, the present disclosure may be modified in a variety of ways and realized in many different forms. Accordingly, it will be appreciated that the present disclosure is not limited to the specific disclosed forms, and should be construed to include all modifications, equivalents, or replacements included within the scope of the present disclosure.

In addition, spatially relative terms, such as "below", "lower", "above", "upper" and the like, may be used herein for ease of description to describe one element or feature's relationship to another element or feature as shown in the figures.

In the case of a vehicle display device, when the image displayed on the vehicle display device located in front of the driver or passenger is reflected on the windshield at night, it may interfere with the driver's driving. Therefore, it may be necessary or desirable to control the viewing angle of the image displayed on the vehicle display device. In addition, in order to protect the privacy of a viewer of the image, it may be necessary or desirable to control the viewing angle of the image displayed on the vehicle display device such that the image displayed on the vehicle display device located in front of the driver is not provided to the passenger. In addition, the vehicle display device, which is located between the driver and the passenger, i.e., in the center of a dashboard, may need to provide different images to the driver and the passenger. For example, information to be displayed to the driver and the passenger may be different.

It will also be understood that when a layer is referred to as being "on" another layer or substrate, it can be directly on the other layer or substrate, or intervening layers may also be present. The same reference numbers indicate the same components throughout the specification.

It is to be understood that, although the terms "first," "second," etc. may be used herein to describe various elements, these elements should not be limited by these terms. These terms are used to distinguish one element from another element. For instance, a first element discussed below could be termed a second element without departing from the teachings of the present disclosure. Similarly, the second element could also be termed a first element.

Hereinafter, embodiments of the present disclosure will be described in detail with reference to the accompanying drawings. When describing with reference to the drawings, identical or corresponding components are given the same drawing reference numerals and redundant descriptions thereof are omitted.

In the examples below, singular expressions include plural expressions unless the context clearly indicates otherwise.

In the examples below, terms such as "include" or "have" mean that a feature or component described in the specification is present, and do not exclude in advance the possibility that one or more other features or components may be added.

In the following examples, when a part such as a film, region, component, etc. is said to be on or above another part, it includes not only the case where it is directly on top of the other part, but also the case where another film, region, component, etc. is interposed in between.

In the drawings, sizes of components may be exaggerated or reduced for convenience of explanation. For example, a size and thickness of each component shown in the drawing are arbitrarily shown for convenience of explanation, and thus the present implementation of the teachings of the present disclosure are not necessarily limited to what is shown.

Additionally, the terms "about," "generally," and "substantially" are intended to mean, and a person of ordinary skill would understand them to mean that slight deviations from absolute are included within the scope of the term so modified.

In some embodiments, where the implementation is otherwise feasible, specific process sequences may be performed in a different order than described. For example, two processes described sequentially may be performed substantially simultaneously, or may proceed in the reverse order from that described.

In this specification, "A and/or B" refers to either A, B, or both A and B. And, "at least one of A and B" indicates the case where it is A, or B, or both A and B.

In the following examples, when it is said that a film, region, component, etc. are connected, it includes a case where the films, regions, or components are directly connected, and/or a case where other films, regions, or components are interposed between the films, regions, or components and are indirectly connected. For example, when it is said in this specification that a film, region, component, etc. are electrically connected, it refers to a case where the film, region, component, etc. are directly electrically connected, and/or a case where another film, region, component, etc. is interposed between them and is indirectly electrically connected.

A display device according to an embodiment may be included in vehicles or other electronic devices. In some aspect, the vehicle or electronic device that includes the display device described above may further include a module or device having additional functions in addition to the display device.

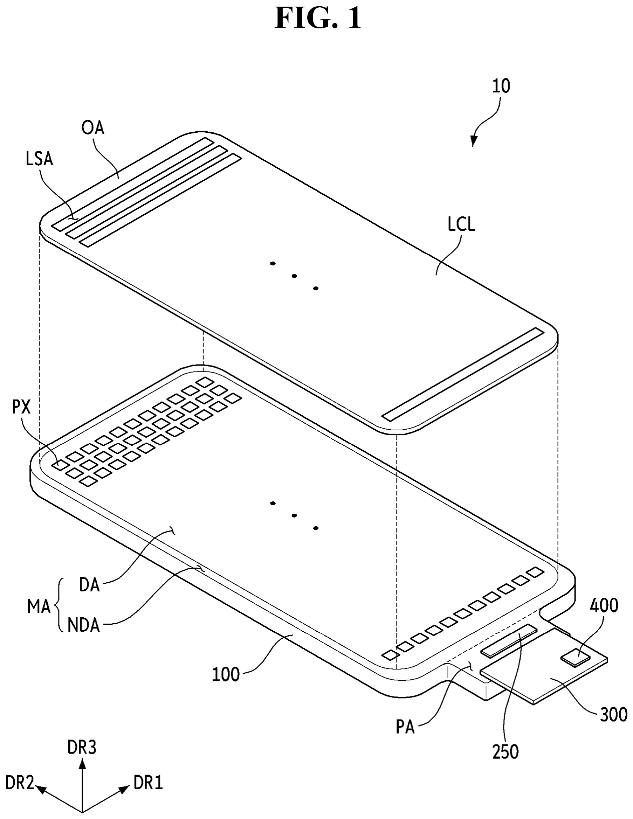

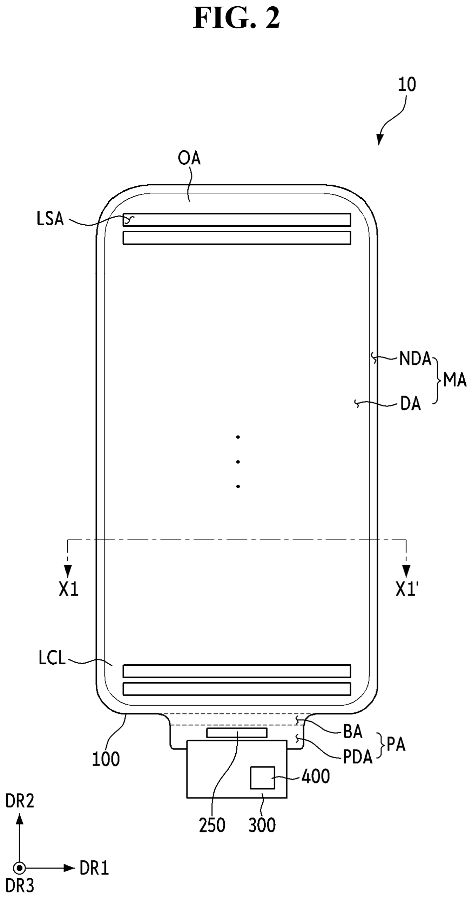

FIG. 1 is a perspective view showing a display device according to an embodiment of the present disclosure. FIG. 2 is a plan view illustrating a display device according to an embodiment of the present disclosure.

Referring to FIGS. 1 and 2, a display device 10, which is a device for displaying a moving image or a still image, may be used as a display screen of various devices, such as an automobile, a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

In some embodiments, when the display device 10 is used as a display screen of a vehicle, the display device 10 may be a vehicle display. The vehicle display may provide users with not only information about vehicle's operation and status, but also various services such as convenience functions and media content. When the display device 10 includes an input unit such as a touch panel, the user may operate various functions such as driving modes of the vehicle and convenience functions through the display device 10.

In this specification, a case where the display device 10 is a vehicle display is described as an example, but the present disclosure is not limited thereto, and even when the display device 10 is used for a display screen of various products such as the above-described electronic devices.

The display device 10 may be any one of an organic light emitting display device, a liquid crystal display device, a plasma display device, a field emission display device, an electrophoretic display device, an electrowetting display device, a quantum dot light emitting display device, a micro LED display device, and the like. In the following description, it is assumed that the display device 10 is an organic light emitting display device, but the present disclosure is not limited thereto.

The display device 10 according to one embodiment may include a display panel 100, a display driving circuit 250, a circuit board 300, and a touch driving circuit 400.

The display panel 100 may include a plurality of pixels PX arranged in a first direction DR1 and a second direction DR2. Each of the pixels PX may have a rectangular, square, or rhombic shape in plan view. For example, as shown in the drawing, each of the pixels PX may have a square shape in plan view. However, it is not limited thereto, and may have various shapes such as a polygon, a circle, and an ellipse in plan view.

In the illustrated figure, the first direction DR1 and the second direction DR2 cross each other as horizontal directions. For example, the first direction DR1 and the second direction DR2 may be orthogonal to each other. In addition, a third direction DR3 crosses the first direction DR1 and the second direction DR2, and may be, for example, perpendicular directions orthogonal to each other. In the present disclosure, a direction indicated by each of the first to third directions DR1, DR2, and DR3 on the drawings may be referred to as one side, and an opposite direction thereto may be referred to as the other side. Namely, the one side is a first side with respect to a first plane, the first plane being in a thickness direction. The other side is a second side with respect to the first plane, the second side being opposite the first side. Unless otherwise specified, each direction may include opposite sides. Unless otherwise defined, in the present specification, directions indicated by arrows of the first to third directions DR1, DR2, and DR3 may be referred to as one side, and the opposite directions thereto may be referred to as the other side. Also, the terms "above," "upper side," "upper portion," "top," and "top surface," as used herein, refer to a direction indicated by an arrow in the drawing in the third direction DR3 based on the drawings, and the terms "below," "lower side," "lower portion," "bottom," and "bottom surface," as used herein, refer to a direction opposite to the direction indicated by the arrow in the third direction DR3 based on the drawings.

The display panel 100 may include a main region MA and a protrusion area PA protruding from one side of the main region MA.

The main region MA may, in plan view, be formed in a rectangular shape having short sides in the first direction DR1 and long sides in the second direction DR2 crossing the first direction DR1. The corner where the short side in the first direction DR1 and the long side in the second direction DR2 meet may be rounded to have a selected curvature or may be right-angled. The planar shape of the display device 10 is not limited to a quadrilateral shape, and may be formed in another polygonal shape, a circular shape, or an elliptical shape. The main region MA may be formed flat, but is not limited thereto, and may include curved portions formed at left and right ends. In this case, the curved portions may have a constant curvature or a changing curvature.

The main region MA may include a display area DA where pixels are formed to display an image and a non-display area NDA which is a peripheral area of the display area DA.

In the display area DA, not only the pixels, but also scan lines, data lines, and power lines connected to the pixels may be located. When the main region MA includes a curved portion, the display area DA may be located on the curved portion. In this case, the image of the display panel 100 may also be seen on the curved portion.

The non-display area NDA may be defined as an area from the boundary of the display area DA to the edge of the display panel 100. A scan driver for applying scan signals to the scan lines and link lines connecting the data lines to the display driving circuit 250 may be located in the non-display area NDA.

The protrusion area PA may protrude from one side of the main region MA. For example, the protrusion area PA may protrude from the lower side of the main region MA as shown in FIG. 2. A length of the protrusion area PA in the first direction DR1 may be less than a length of the main region MA in the first direction DR1.

The protrusion area PA may include a bending area BA and a pad area PDA. In this case, the pad area PDA may be located on one side of the bending area BA, and the main region MA may be located on the other side of the bending area BA. For example, the pad area PDA may be located below the bending area BA, and the main region MA may be located above the bending area BA.

The display panel 100 may be formed flexibly such that it can be curved, bent, folded, or rolled. Accordingly, the display panel 100 may be bent in the thickness direction, that is, in the third direction DR3 in the bending area BA. In this case, one surface of the pad area PDA of the display panel 100 faces upward before the display panel 100 is bent, but after the display panel 100 is bent, one surface of the pad area PDA of the display panel 100 faces downward. Accordingly, since the pad area PDA is located below the main region MA, the pad area PDA may overlap the main region MA.

Pads electrically connected to the display driving circuit 250 and the circuit board 300 may be located in the pad area PDA of the display panel 100.

The display driving circuit 250 outputs signals and voltages for driving the display panel 100. For example, the display driving circuit 250 may supply data voltages to data lines. Further, the display driving circuit 250 may supply a power voltage to the power line, and may supply scan control signals to the scan driver. The display driving circuit 250 may be formed as an integrated circuit (IC) and mounted on the display panel 100 in the pad area PDA by a chip on glass (COG) method, a chip on plastic (COP) method, or an ultrasonic bonding method, but the present disclosure is not limited thereto. For example, the display driving circuit 250 may be mounted on the circuit board 300.

The pads may include display pads electrically connected to the display driving circuit 250 and touch pads electrically connected to touch lines.

The circuit board 300 may be attached onto the pads using an anisotropic conductive film. Accordingly, lead lines of the circuit board 300 may be electrically connected to the pads. The circuit board 300 may be a flexible printed circuit board, a printed circuit board, or a flexible film such as a chip on film.

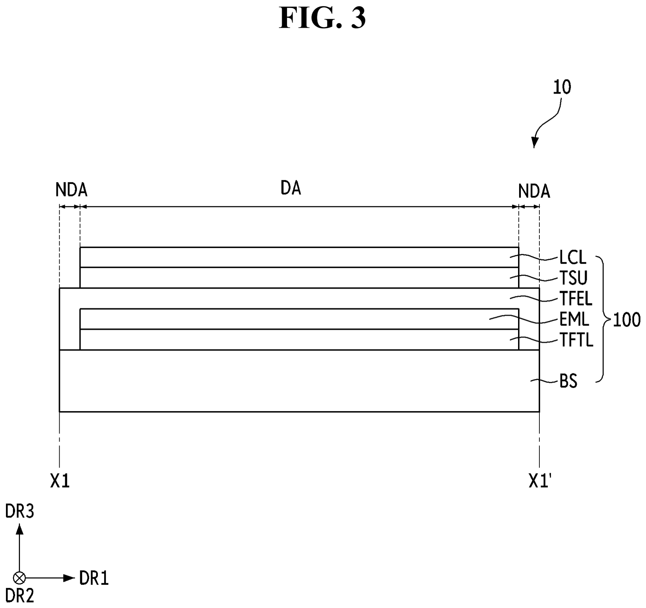

The touch driving circuit 400 may be connected to touch electrodes of a touch sensor layer TSU (see FIG. 3) of the display panel 100. The touch driving circuit 400 applies driving signals to the touch electrodes of the touch sensor layer TSU (see FIG. 3) and measures capacitance values of the touch electrodes. The driving signal may be a signal having a plurality of driving pulses. The touch driving circuit 400 may determine whether or not touch is inputted based on the capacitance values, and may calculate touch coordinates at which touch is inputted.

The touch driving circuit 400 may be located on the circuit board 300. The touch driving circuit 400 may be formed as an integrated circuit (IC) and mounted on the circuit board 300.

In the display device 10 according to the present embodiment, the display panel 100 may further include a light control layer LCL.

The light control layer LCL may be directly located on the main region MA of the display panel 100. For example, the light control layer LCL may be embedded in the display panel 100 and directly located on the main region MA of the display panel 100. By embedding the light control layer LCL in the display panel 100, the thickness and manufacturing cost of the display device 10 may be reduced compared to a case where a separate light control film is attached.

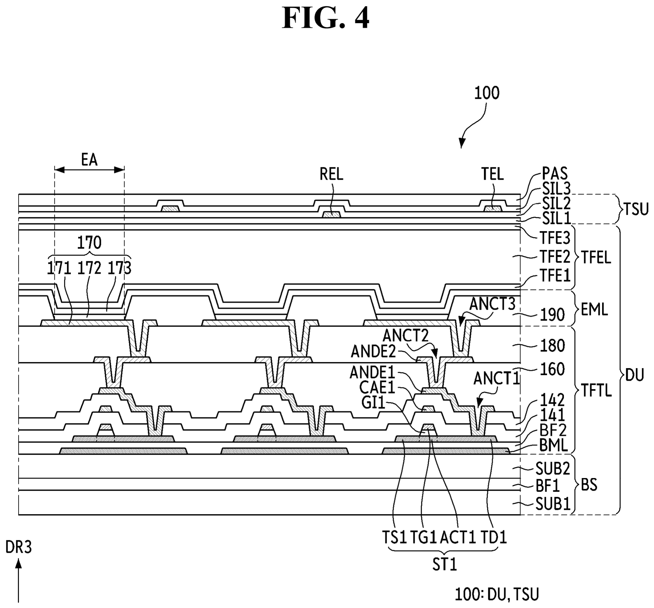

In some embodiments, the light control layer LCL may be located on the display area DA of the main region MA. The light control layer LCL may adjust the viewing angle of light emitted from a light emitting layer 172 (see FIG. 4) of the display panel 100.

However, it is not limited thereto, and the size of the light control layer LCL may be larger than that of the display area DA in plan view. In this case, the light control layer LCL may overlap both the display area DA and the non-display area NDA.

In some embodiments, the light control layer LCL may include a transmission area OA and a non-transmission area LSA.

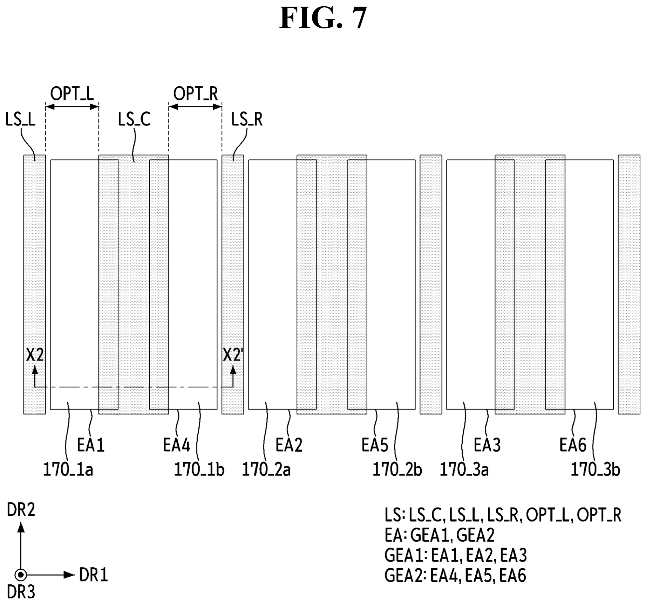

The transmission area OA may be an area in which light emitted from the light emitting layer 172 (see FIG. 4) is emitted without being blocked by a light blocking film LS (see FIG. 7). The transmission area OA may be an area that transmits light.

The transmission area OA may have a quadrilateral shape in plan view, as illustrated in FIGS. 1 and 2, but is not limited thereto. The transmission area OA may have a circular shape, an elliptical shape, or a polygonal shape in plan view. In some embodiments, the shape of the transmission area OA may substantially correspond to the shape of the display panel 100.

The non-transmission areas LSA may be the remaining areas of the light control layer LCL excluding the transmission areas OA. The non-transmission areas LSA may be areas where light emitted from the light emitting layer 172 (see FIG. 4) is blocked by the light blocking film LS (see FIG. 7).

In some embodiments, the non-transmission areas LSA may extend in the first direction DR1 or the second direction DR2. For example, as shown in FIG. 1, the non-transmission areas LSA may extend in the first direction DR1 and may be arranged along the second direction DR2. As another example, the non-transmission areas LSA may extend in the second direction DR2 and may be arranged along the first direction DR1. As still another example, some of the non-transmission areas LSA may extend in the first direction DR1 and may be arranged along the second direction DR2, while the remainder of the non-transmission areas LSA may extend in the second direction DR2 and may be arranged along the first direction DR1.

In one embodiment, as shown in FIG. 1, when the non-transmission areas LSA are arranged along the second direction DR2, the viewing angle may be controlled in the second direction DR2. In another embodiment, when the non-transmission areas LSA are arranged along the first direction DR1, the viewing angle may be controlled in the first direction DR1. In the display device 10 according to this embodiment, the arrangement and shape of the transmission areas OA and the non-transmission areas LSA may be changed in various ways according to the required control direction of the viewing angle.

Although it is illustrated in the drawing that the transmission area OA is located to surround the non-transmission areas LSA, the present disclosure is not limited thereto. In some embodiments, the transmission area OA may include a plurality of transmission areas OA, and the plurality of transmission areas OA may extend in the same direction as the non-transmission areas LSA, so that the transmission areas OA and the non-transmission areas LSA may be arranged alternately with each other. For example, as shown in FIG. 1, when the non-transmission areas LSA extend in the first direction DR1, the plurality of transmission areas OA may extend in the first direction DR1 and may be arranged alternately with the non-transmission areas LSA in the second direction DR2.

FIG. 3 is a schematic cross-sectional view of the display device taken along line X1-X1' of FIG. 2.

Referring to FIG. 3, the display device 10 may include the display panel 100 in which the light control layer LCL is embedded. The display panel 100 may include a base member BS, a thin film transistor layer TFTL, a light emitting element layer EML, a thin film encapsulation layer TFEL, the touch sensor layer TSU, and the light control layer LCL.

The base member BS may include a substrate. The substrate may include an insulating material such as glass, quartz, or a polymer resin. Examples of a polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (TAC), cellulose acetate propionate (CAP), or a combination thereof. Alternatively, the substrate may include a metal material.

The substrate may be a rigid substrate or a flexible substrate which can be bent, folded or rolled. When the substrate is a flexible substrate, the substrate may include polyimide (PI), but is not limited thereto.

The thin film transistor layer TFTL may be located on the base member BS. In the thin film transistor layer TFTL, scan lines, data lines, power lines, scan control lines, and link lines connecting pads to data lines, as well as thin film transistors of each of the pixels, may be formed. Each of the thin film transistors may include a gate electrode, a semiconductor layer, a source electrode, and a drain electrode.

The thin film transistor layer TFTL may be located in the display area DA and the non-display area NDA. Specifically, thin film transistors, scan lines, data lines, and power lines of each of the pixels of the thin film transistor layer TFTL may be located in the display area DA. The scan control lines and the link lines of the thin film transistor layer TFTL may be located in the non-display area NDA.

The light emitting element layer EML may be located on the thin film transistor layer TFTL. The light emitting element layer EML may include pixels including a first electrode, a light emitting layer, and a second electrode, and a pixel defining film defining the pixels. The light emitting layer may be an organic light emitting layer containing an organic material. In this case, the light emitting layer may include a hole transporting layer, an organic light emitting layer, and an electron transporting layer. When the first electrode is applied with a selected voltage through the thin film transistor of the thin film transistor layer TFTL and the second electrode is applied with a cathode voltage, holes and electrons are transferred to the organic light emitting layer through a hole transporting layer and an electron transporting layer, respectively and are combined with each other to emit light in the organic light emitting layer. The pixels of the light emitting element layer EML may be located in the display area DA.

The thin film encapsulation layer TFEL may be located on the light emitting element layer EML. The thin film encapsulation layer TFEL may serve to prevent oxygen or moisture from permeating into the light emitting element layer EML. To this end, the thin film encapsulation layer TFEL may include at least one inorganic film. The inorganic film may be a silicon nitride layer, a silicon oxynitride layer, a silicon oxide layer, a titanium oxide layer, or an aluminum oxide layer, but is not limited thereto. In addition, the thin film encapsulation layer TFEL may serve to protect the light emitting element layer EML from foreign substances such as dust. To this end, the thin film encapsulation layer TFEL may include at least one organic film. The organic film may include acryl resin, epoxy resin, phenolic resin, polyamide resin, or polyimide resin, but is not limited thereto.

The thin film encapsulation layer TFEL may be located in both the display area DA and the non-display area NDA. Specifically, the thin film encapsulation layer TFEL may cover the light emitting element layer EML in the display area DA and the non-display area NDA, and may be located to cover the thin film transistor layer TFTL in the non-display area NDA.

The touch sensor layer TSU may be located on the thin film encapsulation layer TFEL. Since the touch sensor layer TSU is directly located on the thin film encapsulation layer TFEL, it has the advantage of reducing the thickness of the display device 10 compared to a case where a separate touch panel including the touch sensor layer TSU is attached on the thin film encapsulation layer TFEL.

The touch sensor layer TSU may include touch electrodes for sensing a user's touch in a capacitive manner and the touch lines connecting the pads to the touch electrodes. For example, the touch sensor layer TSU may sense a user's touch using a self-capacitance method or a mutual capacitance method.

The touch electrodes of the touch sensor layer TSU may be located in a touch sensor area overlapping the display area DA. The touch lines of the touch sensor layer TSU may be located in a touch peripheral area overlapping the non-display area NDA.

The light control layer LCL may be located on the touch sensor layer TSU. The light control layer LCL may be located to overlap the display area DA. The light control layer LCL may serve to absorb or block light that travels out of a certain angle with respect to the third direction DR3 among light emitted from the light emitting element layer EML. That is, the light control layer LCL may control the viewing angle.

Although not shown in the drawing, the display device 10 may further include a cover window. The cover window may be additionally located on the light control layer LCL, and in this case, the light control layer LCL and the cover window may be attached by a transparent adhesive member such as an optically clear adhesive (OCA) film.

FIG. 4 is a cross-sectional view illustrating an example of a display panel according to one embodiment of the present disclosure.

Referring to FIG. 4, the display panel 100 may include a display layer DU and the touch sensor layer TSU. The display layer DU may include the base member BS, the thin film transistor layer TFTL, the light emitting element layer EML, and the thin film encapsulation layer TFEL.

The base member BS may include a first substrate SUB1, a first buffer film BF1 located on the first substrate SUB1, and a second substrate SUB2 located on the first buffer film BF1.

The first substrate SUB1 and the second substrate SUB2 may be made of an insulating material such as glass, quartz, polymer resin or the like. Examples of a polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (TAC), cellulose acetate propionate (CAP), or a combination thereof. Alternatively, the substrate may include a metal material.

The first substrate SUB1 and the second substrate SUB2 may be a rigid substrate, or a flexible substrate which can be bent, folded or rolled. When the substrate is a flexible substrate, the substrate may include polyimide (PI), but is not limited thereto.

The first buffer film BF1 is a film for protecting a first thin film transistor ST1 and the light emitting layer 172 from moisture permeating through the first substrate SUB1 and the second substrate SUB2 which are susceptible to moisture permeation. The first buffer film BF1 may include a plurality of inorganic films that are alternately stacked. For example, the first buffer film BF1 may be formed as multiple films in which one or more inorganic films of a silicon nitride layer, a silicon oxynitride layer, a silicon oxide layer, a titanium oxide layer and an aluminum oxide layer are alternately stacked.

The thin film transistor layer TFTL may include a lower metal layer BML, a second buffer film BF2, the first thin film transistor ST1, a first gate insulating film GI1, a first interlayer insulating film 141, a first capacitor electrode CAE1, a second interlayer insulating film 142, a first anode connection electrode ANDE1, a first organic film 160, a second anode connection electrode ANDE2, and a second organic film 180.

The lower metal layer BML may be located on the second substrate SUB2. The lower metal layer BML may be located to overlap a first active layer ACT1 of the first thin film transistor ST1 in the third direction DR3 in order to prevent a leakage current from being generated when light is incident on the first active layer ACT1 of the first thin film transistor ST1. The lower metal layer BML may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. The lower metal layer BML may be omitted.

The second buffer film BF2 may be located on the lower metal layer BML. The second buffer film BF2 is a film for protecting the first thin film transistor ST1 and the light emitting layer 172 from moisture permeating through the first substrate SUB1 and the second substrate SUB2 which are susceptible to moisture permeation. The second buffer film BF2 may be formed as a plurality of inorganic films that are alternately stacked. For example, the second buffer film BF2 may be formed as multiple films in which one or more inorganic films of a silicon nitride layer, a silicon oxynitride layer, a silicon oxide layer, a titanium oxide layer and an aluminum oxide layer are alternately stacked.

The first active layer ACT1 of the first thin film transistor ST1 may be located on the second buffer film BF2. The first active layer ACT1 of the first thin film transistor ST1 includes polycrystalline silicon, monocrystalline silicon, low-temperature polycrystalline silicon, amorphous silicon, or an oxide semiconductor. The first active layer ACT1 of the first thin film transistor ST1, which is exposed without being covered by the first gate insulating film GI1, is doped with impurities or ions, and thus may have conductivity. Accordingly, a first source electrode TS1 and a first drain electrode TD1 of the first active layer ACT1 of the first thin film transistor ST1 may be formed.

The first gate insulating film GI1 may be located on the first active layer ACT1 of the first thin film transistor ST1. Although FIG. 4 illustrates that the first gate insulating film GI1 is located between the first active layer ACT1 and a first gate electrode TG1 of the first thin film transistor ST1, but is not limited thereto. The first gate insulating film GI1 may be located between the first interlayer insulating film 141 and the first active layer ACT1 and between the first interlayer insulating film 141 and the second buffer film BF2. The first gate insulating film GI1 may be formed as an inorganic film, for example, a silicon nitride layer, a silicon oxynitride layer, a silicon oxide layer, a titanium oxide layer, or an aluminum oxide layer.

The first gate electrode TG1 of the first thin film transistor ST1 may be located on the first gate insulating film GI1. The first gate electrode TG1 of the first thin film transistor ST1 may overlap the first active layer ACT1 in the third direction DR3. The first gate electrode TG1 of the first thin film transistor ST1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first interlayer insulating film 141 may be located on the first gate electrode TG1 of the first thin film transistor ST1. The first interlayer insulating film 141 may be formed as an inorganic film, for example, a silicon nitride layer, a silicon oxynitride layer, a silicon oxide layer, a titanium oxide layer, or an aluminum oxide layer. The first interlayer insulating film 141 may include a plurality of inorganic films.

The first capacitor electrode CAE1 may be located on the first interlayer insulating film 141. The first capacitor electrode CAE1 may overlap the first gate electrode TG1 of the first thin film transistor ST1 in the third direction DR3. Since the first interlayer insulating film 141 has a selected dielectric constant, the first capacitor electrode CAE1, the first gate electrode TG1, and the first interlayer insulating film 141 located between the first capacitor electrode CAE1 and the first gate electrode TG1may form a capacitor. The first capacitor electrode CAE1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second interlayer insulating film 142 may be located on the first capacitor electrode CAE1. The second interlayer insulating film 142 may be formed as an inorganic film, for example, a silicon nitride layer, a silicon oxynitride layer, a silicon oxide layer, a titanium oxide layer, or an aluminum oxide layer. The second interlayer insulating film 142 may include a plurality of inorganic films.

The first anode connection electrode ANDE1 may be located on the second interlayer insulating film 142. The first anode connection electrode ANDE1 may penetrate through the first interlayer insulating film 141 and the second interlayer insulating film 142 to be connected to the first drain electrode TD1 of the first thin film transistor ST1 via a first anode contact hole ANCT1 that exposes the first drain electrode TD1 of the first thin film transistor ST1. The first anode connection electrode ANDE1 may be formed as a single layer or multiple layers containing any one of molybdenum (Mo), aluminum (Al), chromium (Cr), gold (Au), titanium (Ti), nickel (Ni), neodymium (Nd) and copper (Cu), or an alloy thereof.

The first organic film 160 for planarization may be located on the first anode connection electrode ANDE1. The first organic film 160 may be formed as an organic film such as acrylic resin, epoxy resin, phenolic resin, polyamide resin, polyimide resin and the like.

The second anode connection electrode ANDE2 may be located on the first organic film 160. The second anode connection electrode ANDE2 may be connected to the first anode connection electrode ANDE1 via the second anode contact hole ANCT2 penetrating the first organic film 160 to expose the first anode connection electrode ANDE1. The second anode connection electrode ANDE2 may be formed as a single layer or multiple layers containing any one of molybdenum (Mo), aluminum (Al), chromium (Cr), gold (Au), titanium (Ti), nickel (Ni), neodymium (Nd) and copper (Cu), or an alloy thereof.

The second organic film 180 may be located on the second anode connection electrode ANDE2. The second organic film 180 may be formed as an organic film such as acrylic resin, epoxy resin, phenolic resin, polyamide resin, polyimide resin and the like.

Although FIG. 4 illustrates that the first thin film transistor ST1 is configured to be of a top gate type in which the first gate electrode TG1 is located on top of the first active layer ACT1, the present disclosure is not limited thereto. The first thin film transistor ST1 may be configured to be of a bottom gate type in which the first gate electrode TG1 is located under the first active layer ACT1, or a double gate type in which the first gate electrode TG1 is located on and under the first active layer ACT1.

The light emitting element layer EML may be located on the second organic film 180. The light emitting element layer EML may include light emitting elements 170 and a bank 190. Each of the light emitting elements 170 may include a first light emitting electrode 171, the light emitting layer 172, and a second light emitting electrode 173.

The first light emitting electrode 171 may be formed on the second organic film 180. The first light emitting electrode 171 may penetrate through the second organic film 180 to be connected to the second anode connection electrode ANDE2 via the third anode contact hole ANCT3 that exposes the second anode connection electrode ANDE2.

In a top emission structure in which light is emitted toward the second light emitting electrode 173 when viewed with respect to the light emitting layer 172, the first light emitting electrode 171 may include a metal material having high reflectivity to have a stacked structure (Ti/Al/Ti) of aluminum and titanium, a stacked structure (ITO/AI/ITO) of aluminum and ITO, an APC alloy, and a stacked structure (ITO/APC/ITO) of an APC alloy and ITO. The APC alloy is an alloy of silver (Ag), palladium (Pd) and copper (Cu).

The bank (or pixel defining film) 190 may be formed on the second organic film 180 to partition the first light emitting electrode 171, thereby defining an emission area EA. The bank 190 may include an opening that exposes at least a part of the top surface of the first light emitting electrode 171. The bank 190 may be formed to cover the edge of the first light emitting electrode 171. The bank 190 may be formed as an organic film such as acrylic resin, epoxy resin, phenolic resin, polyamide resin, polyimide resin and the like.

The emission area EA represents an area in which the first light emitting electrode 171, the light emitting layer 172, and the second light emitting electrode 173 are sequentially stacked, and holes from the first light emitting electrode 171 and electrons from the second light emitting electrode 173 are combined with each other in the light emitting layer 172 to emit light. The emission area EA may be defined by the opening of the bank 190.

The light emitting layer 172 is formed on the first light emitting electrode 171 and the bank 190. The light emitting layer 172 may be located in the opening of the bank 190, but is not limited thereto. The light emitting layer 172 may include an organic material to emit light of a selected color. For example, the light emitting layer 172 may include a hole transporting layer, an organic material layer, and an electron transporting layer.

The second light emitting electrode 173 may be located on the light emitting layer 172. The second light emitting electrode 173 may be formed to cover the light emitting layer 172. The second light emitting electrode 173 may be a common layer formed in common for all the emission areas EA. Although not shown, in some embodiments, a capping layer may be formed on the second light emitting electrode 173.

In the top emission structure, the second light emitting electrode 173 may include transparent conductive oxide (TCO) such as indium tin oxide (ITO) and indium zinc oxide (IZO) capable of transmitting light or a semi-transmissive conductive material such as magnesium (Mg), silver (Ag), or an alloy of magnesium (Mg) and silver (Ag). When the second light emitting electrode 173 includes a semi-transmissive conductive material, the light emission efficiency may be increased due to a micro-cavity effect.

The thin film encapsulation layer TFEL may be located on the second light emitting electrode 173. The thin film encapsulation layer TFEL may include at least one inorganic film to prevent oxygen or moisture from permeating into the light emitting element layer. In addition, the thin film encapsulation layer TFEL may include at least one organic film to protect the light emitting element layer from foreign substances such as dust. For example, the thin film encapsulation layer TFEL may include a first encapsulation film TFE1, a second encapsulation film TFE2, and a third encapsulation film TFE3.

The first encapsulation film TFE1 (e.g., a first inorganic encapsulation film) may be located on the second light emitting electrode 173. The first encapsulation film TFE1 may be an inorganic film of a single layer or multiple layers. The first encapsulation film TFE1 may be formed as a single layer or a multilayer in which one or more inorganic films of a silicon nitride layer, a silicon oxynitride layer, a silicon oxide layer, a titanium oxide layer and an aluminum oxide layer are alternately stacked.

The second encapsulation film TFE2 (e.g., a first organic encapsulation film) may be located on the first encapsulation film TFE1. The second encapsulation film TFE2 may be an organic film of a single layer or multiple layers. The second encapsulation film TFE2 may include a polymer-based material. Polymer-based materials may include polyethylene terephthalate, polyethylene naphthalate, polycarbonate, polyimide, polyethylene sulfonate, polyoxymethylene, polyarylate, hexamethyldisiloxane, and acrylic resins (e.g., polymethyl methacrylate, polyacrylic acid, or the like), or any combination thereof.

The third encapsulation film TFE3 (e.g., a second inorganic encapsulation film) may be located on the second encapsulation film TFE2. The third encapsulation film TFE3 may be an inorganic film of a single layer or multiple layers. The third encapsulation film TFE3 may include the same material as the first encapsulation film TFE1. For example, the third encapsulation film TFE3 may be formed as a single layer or a multilayer in which one or more inorganic films of a silicon nitride layer, a silicon oxynitride layer, a silicon oxide layer, a titanium oxide layer and an aluminum oxide layer are alternately stacked.

The touch sensor layer TSU may be located on the thin film encapsulation layer TFEL. The touch sensor layer TSU may include a plurality of touch electrodes for sensing a user's touch in a capacitive manner and the touch lines connecting the plurality of touch electrodes to a touch driver. For example, the touch sensor layer TSU may sense the user's touch by using a mutual capacitance method or a self-capacitance method.

In another embodiment, the touch sensor layer TSU may be located on a separate substrate located on the display layer DU. In this case, the substrate supporting the touch sensor layer TSU may be an encapsulation member encapsulating the display layer DU.

The plurality of touch electrodes of the touch sensor layer TSU may be located in a touch sensor area overlapping the display area. The touch lines of the touch sensor layer TSU may be located in the touch peripheral area overlapping the non-display area.

The touch sensor layer TSU may include a first touch insulating film SIL1, a first touch electrode REL, a second touch insulating film SIL2, a second touch electrode TEL, and a third touch insulating film SIL3.

The first touch insulating film SIL1 may be located on the thin film encapsulation layer TFEL. The first touch insulating film SIL1 may have insulating and optical functions. The first touch insulating film SIL1 may include at least one inorganic film. For example, the first touch insulating film SIL1 may be an inorganic film containing at least one of a silicon nitride layer, a silicon oxynitride layer, a silicon oxide layer, a titanium oxide layer, or an aluminum oxide layer. Optionally, the first touch insulating film SIL1 may be omitted.

The first touch electrode REL may be located on the first touch insulating film SIL1. The first touch electrode REL may not overlap the light emitting element 170. The first touch electrode REL may be formed as a single layer containing molybdenum (Mo), titanium (Ti), copper (Cu), aluminum (Al), or indium tin oxide (ITO), or may be formed to have a stacked structure (Ti/Al/Ti) of aluminum and titanium, a stacked structure (ITO/AI/ITO) of aluminum and ITO, an Ag-Pd-Cu (APC) alloy, or a stacked structure (ITO/APC/ITO) of APC alloy and ITO.

The second touch insulating film SIL2 may cover the first touch electrode REL and the first touch insulating film SIL1. The second touch insulating film SIL2 may have insulating and optical functions. For example, the second touch insulating film SIL2 may be made of the material exemplified in association with the first touch insulating film SIL1.

The second touch electrode TEL may be located on the second touch insulating film SIL2. The second touch electrode TEL may not overlap the light emitting element 170. The second touch electrode TEL may be formed as a single layer containing molybdenum (Mo), titanium (Ti), copper (Cu), aluminum (Al), or indium tin oxide (ITO), or may be formed to have a stacked structure (Ti/Al/Ti) of aluminum and titanium, a stacked structure (ITO/AI/ITO) of aluminum and ITO, an Ag-Pd-Cu (APC) alloy, or a stacked structure (ITO/APC/ITO) of APC alloy and ITO.

The third touch insulating film SIL3 may cover the second touch electrode TEL and the second touch insulating film SIL2. The third touch insulating film SIL3 may have insulating and optical functions. The third touch insulating film SIL3 may be made of the material exemplified in association with the second touch insulating film SIL2.

In some embodiments, the first touch insulating film SIL1, the second touch insulating film SIL2, and the third touch insulating film SIL3 may be organic films. Each of the first touch insulating film SIL1, the second touch insulating film SIL2, and the third touch insulating film SIL3 may be an organic film such as acryl resin, epoxy resin, phenolic resin, polyamide resin, polyimide resin, or the like.

The touch sensor layer TSU may further include a planarization film PAS for planarization. The planarization film PAS may be formed as an organic film such as acryl resin, epoxy resin, phenolic resin, polyamide resin, polyimide resin and the like.

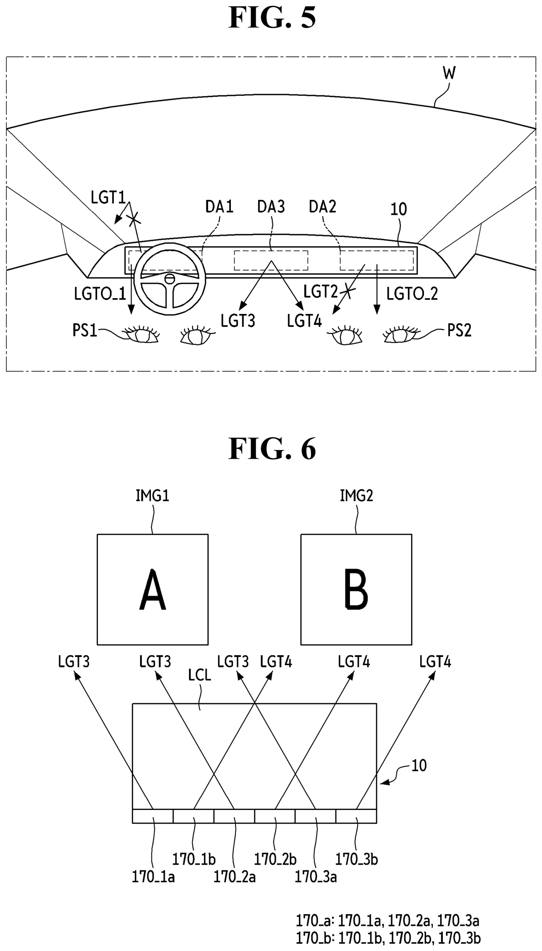

FIG. 5 is a schematic diagram when a display device is applied to a vehicle according to one embodiment of the present disclosure.

Referring to FIG. 5, the display device 10 according to one embodiment may be, for example, the display device applied to the vehicle. The above vehicle may include a vehicle body forming the external appearance of the vehicle, an interior space defined by the vehicle body, and a dashboard located within the interior space. The vehicle body may include a windshield W that protects a driver PS1 and a passenger PS2 from the outside and provides a view to the driver PS1.

As illustrated in the drawing, the display device 10 may be provided on the dashboard in the interior space. For example, as shown in FIG. 5, the display device 10 may extend from the dashboard located in front of the driver's seat to the dashboard located in front of the passenger seat. For example, the display device 10 may be an integral display continued from the dashboard located in front of the driver's seat to the dashboard located in front of the passenger seat.

In this case, the display device 10 may include a first display area DA1 located in front of the driver's seat, a second display area DA2 positioned in front of the passenger seat, and a third display area DA3 positioned between the first display area DA1 and the second display area DA2. The first display area DA1 may be located on the dashboard in front of the driver's seat to provide speed information or the like to the driver PS1, the second display area DA2 may be located on the dashboard in front of the passenger seat to provide entertainment information or the like to the passenger PS2, and the third display area DA3 may provide map information, music information, temperature information, or the like or may provide various functions capable of operating convenient functions that assist in driving the vehicle.

The first display area DA1 may be referred to as a cluster display area, the second display area DA2 may be referred to as a co-driver display (CDD) area, and the third display area DA3 may be referred to as a center information display (CID) area.

As another example, the display device 10 may be located on the dashboard in front of the driver's seat, the dashboard in front of the passenger seat, and the dashboard between the driver's seat and the passenger seat, respectively. For example, a first display device corresponding to the first display area DA1 may be located on the dashboard in front of the driver's seat, a second display device corresponding to the second display area DA2 may be located on the dashboard in front of the passenger seat, and a third display device corresponding to the third display area DA3 may be located on the dashboard between the driver's seat and the passenger seat, respectively.

The driver PS1 may visually recognize the display screen of the display device 10 through light LGTO_1 emitted from the first display area DA1 toward the driver PS1. However, light LGT1, which is some of the light emitted from the first display area DA1, may be reflected on the surrounding windshield W and provided to the driver PS1. In this case, the image reflected on the windshield W may interfere with the driver PS1's driving. On the other hand, in the case of the display device 10 according to one embodiment, by adjusting the viewing angle of the lights emitted from the display device 10 in a front direction (direction facing the driver PS1), particularly, the vertical viewing angle, the light LGT1 that is some of the light emitted from the first display area DA1 may be prevented from being reflected on the surrounding windshield W and provided to the driver PS1.

The passenger PS2 may visually recognize the display screen of the display device 10 through light LGTO_2 emitted from the second display area DA2 toward the passenger PS2. However, light LGT2, which is some of the light emitted from the second display area DA2, may be provided toward the driver PS1. In this case, the driver PS1 may be restricted from viewing when the vehicle is in motion for safety reasons. In the case of the display device 10 according to one embodiment, by adjusting the viewing angle of the lights emitted from the display device 10 in the front direction (the direction facing the passenger PS2), particularly, the horizontal viewing angle, the light LGT2 that is some of the light emitted from the second display area DA2 may be prevented from being provided to the driver.

Although it is illustrated in the drawing that the display device 10 in front of the driver's seat adjusts the vertical viewing angle, and the display device 10 in front of the passenger seat adjusts the horizontal viewing angle, the present disclosure is not limited thereto. For example, the display device 10 in front of the driver's seat may adjust the horizontal viewing angle, and the display device 10 in front of the passenger seat may adjust the vertical viewing angle. As another example, the display device 10 in front of the driver's seat and the display device 10 in front of the passenger seat may adjust both the vertical viewing angle and the horizontal viewing angle.

In some embodiments, during driving, the information required by the driver PS1 and the passenger PS2 may be different, and in this case, lights LGT3 and LGT4 displaying different images may each be emitted from the third display area DA3. The first image light LGT3 displaying a first image may be emitted from the third display area DA3 toward the driver PS1, and the second image light LGT4 displaying a second image may be emitted from the third display area DA3 toward the passenger PS2.

The driver PS1 may visually recognize the screen (e.g., the first image) of the display device 10 through the first image light LGT3 emitted from the third display area DA3 toward the driver PS1. The passenger PS2 may visually recognize the screen (e.g., the second image) of the display device 10 through the second image light LGT4 emitted from the third display area DA3 toward the passenger PS2.

The display device 10 according to one embodiment may adjust a viewing angle of the first image light LGT3 such that the first image light LGT3 is provided only toward the driver PS1 and is not provided toward the passenger PS2, and may adjust a viewing angle of the second image light LGT4 such that the second image light LGT4 is provided only toward the passenger PS2 and is not provided toward the driver PS1. This will be described later with reference to FIG. 6.

The viewing angle of the light emitted from the first to third display areas DA1, DA2, and DA3 may be adjusted through the light control layer LCL. The viewing angle may be limited to a selected angle range via the light control layer LCL. For example, the viewing angle range having a luminance equal to or greater than a required value may be defined as an effective viewing angle range. A viewing angle having a luminance equal to or greater than the required value may be included within the effective viewing angle range, and a viewing angle having a luminance less than the required value may not be included within the effective viewing angle range. At a viewing angle (a viewing angle within the effective viewing angle range) having a luminance equal to or greater than the required value, the user may visually recognize the image, and at a viewing angle (a viewing angle outside the effective viewing angle range) having a luminance less than the required value, the user may not visually recognize the image.

In some embodiments, when an imaginary line facing the driver PS1 or the passenger PS2 and extending in a direction perpendicular to the display surface of the display device 10 is regarded as a normal line, the effective viewing angle range may be an angle in the range of approximately 0° to 70°, e.g. 5°, 10°, 15°, 20°, 25°, 30°, 35°, 40°, 45°, 50°, 55°, 60° or 45° from the normal line, and the required luminance may be about 3% of the maximum luminance, but the present disclosure is not limited thereto. For example, light emitted from the first display area DA1 and the second display area DA2 may have an effective viewing angle that is set to the range of approximately 0° to 45°, e.g. 5°, 10°, 15°, 20°, 25°, 30°, 35° or 40°, and light emitted from the third display area DA3 may have an effective viewing angle that is set to the range of approximately 10° to 50°, e.g. 15°, 15°, 20°, 25°, 30°, 35°, 40° or 45° , but the present disclosure is not limited thereto.

FIG. 6 is a schematic diagram illustrating how a display device according to one embodiment displays an image.

Referring to FIG. 6 in addition to FIGS. 4 and 5, the display device 10 may include a first light emitting element group 170_a and a second light emitting element group 170_b. Each of the first light emitting element group 170_a and the second light emitting element group 170_b may include a plurality of light emitting elements 170. For example, the first light emitting element group 170_a may include a first light emitting element 170_1a, a second light emitting element 170_2a, and a third light emitting element 170_3a, and the second light emitting element group 170_b may include a fourth light emitting element 170_1b, a fifth light emitting element 170_2b, and a sixth light emitting element 170_3b.

In some embodiments, the first light emitting element 170_1a and the fourth light emitting element 170_1b may emit light of a first color, the second light emitting element 170_2a and the fifth light emitting element 170_2b may emit light of a second color, and the third light emitting element 170_3a and the sixth light emitting element 170_3b may emit light of a third color. The light of the first color may be light of a red wavelength band, the light of the second color may be light of a green wavelength band, and the light of the third color may be light of a blue wavelength band. The red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the present disclosure is not limited thereto.

The first light emitting element group 170_a may implement one color and express white gradation by using the lights emitted from the first light emitting element 170_1a, the second light emitting element 170_2a, and the third light emitting element 170_3a. The second light emitting element group 170_b may implement one color and express white gradation by using the lights emitted from the fourth light emitting element 170_1b, the fifth light emitting element 170_2b, and the sixth light emitting element 170_3b.

Although it is illustrated in the drawing that each of the first light emitting element group 170_a and the second light emitting element group 170_b implements one color through three light emitting elements 170, the present disclosure is not limited thereto. The first light emitting element group 170_a and the second light emitting element group 170_b may implement one color through a number of light emitting elements 170 that is less than or more than three.

The display device 10 according to the present embodiment may adjust the path of light emitted from the first light emitting element group 170_a and the second light emitting element group 170_b through the light control layer LCL located on the first light emitting element group 170_a and the second light emitting element group 170_b. For example, the first image light LGT3 emitted from the first light emitting element group 170_a may travel toward one side (e.g., the left side in the drawing) of the display device 10 by the light control layer LCL, and the second image light LGT4 emitted from the second light emitting element group 170_b may travel toward the other side (e.g., the right side in the drawing) of the display device 10 by the light control layer LCL.

A first image IMG1 may be formed by the first image lights LGT3 that travel toward one side of the display device 10, and a second image IMG2 may be formed by the second image lights LGT4 that travel toward the other side of the display device 10.

As described above with reference to FIG. 5, the driver PS1 may visually recognize the first image IMG1 by the first image light LGT3 emitted from the first light emitting element group 170_a, and the passenger PS2 may visually recognize the second image IMG2 by the second image light LGT4 emitted from the second light emitting element group 170_b.

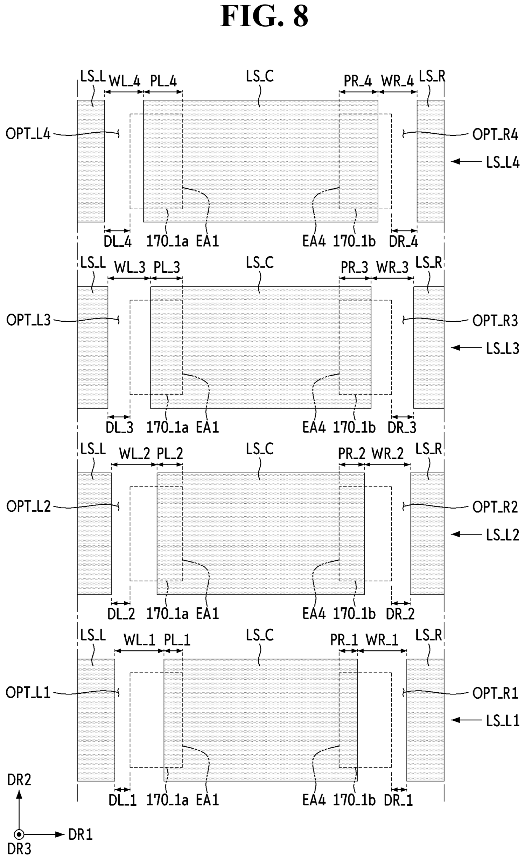

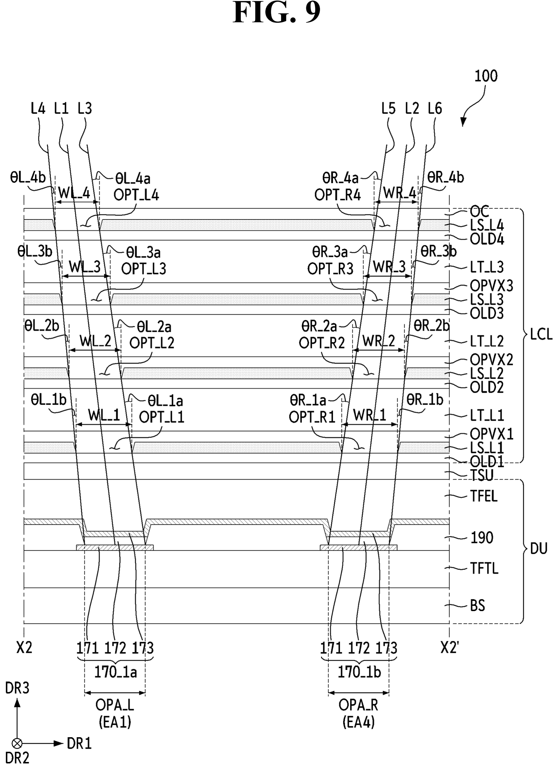

FIG. 7 is a plan view illustrating the planar arrangement of an emission area and a light control layer of a display device according to one embodiment. FIG. 8 is a schematic diagram illustrating the planar arrangement of the emission area and the light control layer of the display device according to one embodiment, divided into layers. FIG. 9 is a cross-sectional view taken along line X2-X2' of FIG. 7.

Referring to FIGS. 7 to 9 in addition to FIGS. 4 to 6, the display device 10 may include a plurality of emission areas EA in which the plurality of light emitting elements 170 are arranged. The emission area EA may be an area in which light generated by the light emitting element 170 is emitted to the outside.

The plurality of emission areas EA may be defined by the bank 190. For example, the plurality of emission areas EA may be areas overlapping the light emitting layer 172 located in openings of the bank 190. The emission area EA may be an area in which the first light emitting electrode 171, the light emitting layer 172, and the second light emitting electrode 173 are sequentially stacked while overlapping each other. A portion in which the first light emitting electrode 171, the light emitting layer 172, and the second light emitting electrode 173 are sequentially stacked while overlapping each other may be the light emitting element 170.

In some embodiments, a plurality of emission areas EA may include a first group area GEA1 and a second group area GEA2. The first group area GEA1 may be partitioned by a first opening OPA_L of the bank 190, and the second group area GEA2 may be partitioned by a second opening OPA_R of the bank 190. The first group area GEA1 may include a first emission area EA1, a second emission area EA2, and a third emission area EA3. The second group area GEA2 may include a fourth emission area EA4, a fifth emission area EA5, and a sixth emission area EA6.

The first emission area EA1 may include the first light emitting element 170_1a, the second emission area EA2 may include the second light emitting element 170_2a, the third emission area EA3 may include the third light emitting element 170_3a, the fourth emission area EA4 may include the fourth light emitting element 170_1b, the fifth emission area EA5 may include the fifth light emitting element 170_2b, and the sixth emission area EA6 may include the sixth light emitting element 170_3b.

In some embodiments, the first emission area EA1 and the fourth emission area EA4 may emit light of the first color, the second emission area EA2 and the fifth emission area EA5 may emit light of the second color, and the third emission area EA3 and the sixth emission area EA6 may emit light of the third color. The light of the first color may be light of a red wavelength band, the light of the second color may be light of a green wavelength band, and the light of the third color may be light of a blue wavelength band. The red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the present disclosure is not limited thereto.

The first group area GEA1 may implement one color and express white gradation by using the lights emitted from the first emission area EA1, the second emission area EA2, and the third emission area EA3. The second group area GEA2 may implement one color and express white gradation by using the lights emitted from the fourth emission area EA4, the fifth emission area EA5, and the sixth emission area EA6.

In the drawing, each of the first group area GEA1 and the second group area GEA2 is illustrated as implementing one color through three emission areas EA, but is not limited thereto. The first group area GEA1 and the second group area GEA2 may implement one color through a number of emission areas EA, which is less than or more than three.

The emission area EA may be defined by the opening of the bank 190. For example, the emission area EA of the first group area GEA1 may be located at the first opening OPA_L (see FIG. 9) described later, and the emission area EA of the second group area GEA2 may be located at the second opening OPA_R (see FIG. 9) described later.

Each of the emission areas EA may have various planar shapes, such as a rectangle, a square, or a rhombus. For example, as illustrated in the drawing, the first to sixth emission areas EA1, EA2, EA3, EA4, EA5, and EA6 may have a rectangular shape, but the present disclosure is not limited thereto.

In one embodiment, as illustrated in FIG. 7, the emission areas EA may each extend in the second direction DR2 and be spaced apart from each other in the first direction DR1. For example, the first to sixth emission areas EA1, EA2, EA3, EA4, EA5, and EA6 may extend in the second direction DR2, and the first emission area EA1, the fourth emission area EA4, the second emission area EA2, the fifth emission area EA5, the third emission area EA3, and the sixth emission area EA6 may be arranged in the first direction DR1 in that order. However, the present disclosure is not limited thereto, and the extension direction and arrangement of the emission area EA may be variously modified.

In the drawing, the areas of the emission areas EA are illustrated as being equal to each other, but are not limited thereto. The areas of the emission areas EA may be different from each other. In some embodiments, the area of the first emission area EA1 may be equal to the area of the fourth emission area EA4, the area of the second emission area EA2 may be equal to the area of the fifth emission area EA5, and the area of the third emission area EA3 may be equal to the area of the sixth emission area EA6.

The display device 10 may further include the light control layer LCL located on the emission area EA. The light control layer LCL may be located on the display layer DU and the touch sensor layer TSU, as illustrated in FIG. 9. The light control layer LCL may control a viewing angle of light emitted from the light emitting layer 172. For example, when the light emitted from the light emitting layer 172 travels within the effective viewing angle range with respect to the third direction DR3, it may be emitted to the outside. On the other hand, when the light emitted from the light emitting layer 172 travels at an angle outside the effective viewing angle range with respect to the third direction DR3, it may be absorbed or blocked by the light blocking film LS and may not be emitted to the outside. In one embodiment, the effective viewing angle range may be approximately 10° to 50°, e.g. 15°, 20°, 25°, 30°, 35°, 40° or 45°, but is not limited thereto.

The light control layer LCL may include the light blocking film LS that blocks or absorbs light emitted from the emission area EA. The light blocking film LS may have a shape extending in the second direction DR2 in plan view. The light blocking film LS may be constituted with a plurality of pieces, and the plurality of light blocking films LS may be arranged alternately with the emission areas EA in the first direction DR1. The light blocking film LS may include a central light blocking film LS_C, a first peripheral light blocking film LS_L, and a second peripheral light blocking film LS_R.

The central light blocking film LS_C may be located between the first emission area EA1 of the first group area GEA1 and the fourth emission area EA4 of the second group area GEA2. The first peripheral light blocking film LS_L may be located on the other side of the first emission area EA1 of the first group area GEA1 in the first direction DR1, and the second peripheral light blocking film LS_R may be located on one side of the fourth emission area EA4 of the second group area GEA2 in the first direction DR1. That is, in the first direction DR1, the first peripheral light blocking film LS_L, the first emission area EA1, the central light blocking film LS_C, the fourth emission area EA4, and the second peripheral light blocking film LS_R may be sequentially arranged.

The central light blocking film LS_C, the first peripheral light blocking film LS_L, and the second peripheral light blocking film LS_R may also be located in the same manner for the second emission area EA2 of the first group area GEA1 and the fifth emission area EA5 of the second group area GEA2. Additionally, the central light blocking film LS_C, the first peripheral light blocking film LS_L, and the second peripheral light blocking film LS_R may also be located in the same manner for the third emission area EA3 of the first group area GEA1 and the sixth emission area EA6 of the second group area GEA2.

For example, the central light blocking film LS_C may be located between the second emission area EA2 of the first group area GEA1 and the fifth emission area EA5 of the second group area GEA2. The first peripheral light blocking film LS_L may be located on the other side of the second emission area EA2 of the first group area GEA1 in the first direction DR1, and the second peripheral light blocking film LS_R may be located on one side of the fifth emission area EA5 of the second group area GEA2 in the first direction DR1. That is, in the first direction DR1, the first peripheral light blocking film LS_L, the second emission area EA2, the central light blocking film LS_C, the fifth emission area EA5, and the second peripheral light blocking film LS_R may be sequentially arranged. Likewise, the central light blocking film LS_C may be located between the third emission area EA3 of the first group area GEA1 and the sixth emission area EA6 of the second group area GEA2. The first peripheral light blocking film LS_L may be located on the other side of the third emission area EA3 of the first group area GEA1 in the first direction DR1, and the second peripheral light blocking film LS_R may be located on one side of the sixth emission area EA6 of the second group area GEA2 in the first direction DR1. That is, in the first direction DR1, the first peripheral light blocking film LS_L, the third emission area EA3, the central light blocking film LS_C, the sixth emission area EA6, and the second peripheral light blocking film LS_R may be sequentially arranged.

At this time, the second peripheral light blocking film LS_R located on one side of the fourth emission area EA4 in the first direction DR1 may have the same configuration as the first peripheral light blocking film LS_L located on the other side of the second emission area EA2 in the first direction DR1. Likewise, the second peripheral light blocking film LS_R located on one side the fifth emission area EA5 in the first direction DR1 may have the same configuration as the first peripheral light blocking film LS_L located on the other side of the third emission area EA3 in the first direction DR1.

Accordingly, in the first direction DR1, the first peripheral light blocking film LS_L, the first emission area EA1, the central light blocking film LS_C, the fourth emission area EA4, the second peripheral light blocking film LS_R (or the first peripheral light blocking film LS_L), the second emission area EA2, the central light blocking film LS_C, the fifth emission area EA5, the second peripheral light blocking film LS_R (or the first peripheral light blocking film LS_L), the third emission area EA3, the central light blocking film LS_C, the sixth emission area EA6, and the second peripheral light blocking film LS_R may be sequentially arranged.

In some embodiments, the central light blocking film LS_C may at least partially overlap the emission areas EA. For example, the other end of the central light blocking film LS_C in the first direction DR1 may overlap the first emission area EA1, the second emission area EA2, and the third emission area EA3 of the first group area GEA1, and one end of the central light blocking film LS_C in the first direction DR1 may overlap the fourth emission area EA4, the fifth emission area EA5, and the sixth emission area EA6 of the second group area GEA2. The first peripheral light blocking film LS_L and the second peripheral light blocking film LS_R may not overlap the emission areas EA.

The light blocking film LS may include a first light transmission opening OPT_L located between the first peripheral light blocking film LS_L and the central light blocking film LS_C, and a second light transmission opening OPT_R located between the central light blocking film LS_C and the second peripheral light blocking film LS_R. The first light transmission opening OPT_L may overlap the first emission area EA1, the second emission area EA2, and the third emission area EA3 of the first group area GEA1. The second light transmission opening OPT_R may overlap the fourth emission area EA4, the fifth emission area EA5, and the sixth emission area EA6 of the second group area GEA2.

Referring to FIG. 9, the stacked structure of the light control layer LCL is described.

The light control layer LCL may include a first medium layer OLD1, a first light blocking layer LS_L1, a first light transmitting lower film OPVX1, a first light transmitting film LT_L1, a second medium layer OLD2, a second light blocking layer LS_L2, a second light transmitting lower film OPVX2, a second light transmitting film LT_L2, a third medium layer OLD3, a third light blocking layer LS_L3, a third light transmitting lower film OPVX3, a third light transmitting film LT_L3, a fourth medium layer OLD4, a fourth light blocking layer LS_L4, and an overcoat layer OC. The first light blocking layer LS_L1, the second light blocking layer LS_L2, the third light blocking layer LS_L3, and the fourth light blocking layer LS_L4 may be included in the light blocking film LS.

The first medium layer OLD1 may be located on the display layer DU and the touch sensor layer TSU. The first medium layer OLD1 may include a transparent inorganic material. For example, the first medium layer OLD1 may include at least one of silicon oxide (SiOₓ), silicon nitride (SiNₓ), or silicon oxynitride (SiOₓN_{y}). In one embodiment, the first medium layer OLD1 may include silicon nitride (SiNₓ), and the thickness of the first medium layer OLD1 may be about 500 Å to 1000 Å, but is not limited thereto. Here, the thickness of the first medium layer OLD1 refers to a distance in the third direction DR3 from the top surface to the bottom surface of the first medium layer OLD1.

The first medium layer OLD1 may be located between the first light transmitting lower film OPVX1 and the organic film (e.g., the planarization film PAS (see FIG. 4) of the touch sensor layer TSU) to increase interfacial properties so that the first light transmitting lower film OPVX1 may be easily deposited on the organic film during the deposition process of the first light transmitting lower film OPVX1. For example, when the first light transmitting lower film OPVX1 is directly deposited on the organic film having interfacial properties different from those of the first light transmitting lower film OPVX1, deposition particles may not be easily deposited on the organic film. On the other hand, when the first medium layer OLD1 is located on the organic film, the deposition particles of the first light transmitting lower film OPVX1 may be easily deposited on the first medium layer OLD1.

The first light blocking layer LS_L1 may be located on the first medium layer OLD1. The first light blocking layer LS_L1 may absorb or block the light emitted from the light emitting layer 172. The first light blocking layer LS_L1 may include a light blocking organic material. In one embodiment, the thickness of the first light blocking layer LS_L1 may be approximately 1 µm to 2 µm, but is not limited thereto. Here, the thickness of the first light blocking layer LS_L1 refers to a distance in the third direction DR3 from the top surface to the bottom surface of the first light blocking layer LS_L1.

The first light blocking layer LS_L1 may include a plurality of first light blocking patterns. The plurality of first light blocking patterns may be spaced apart from each other in the first direction DR1 or the second direction DR2. The plurality of first light blocking patterns may constitute the central light blocking film LS_C, the first peripheral light blocking film LS_L, and the second peripheral light blocking film LS_R illustrated in FIG. 7.

The first light blocking layer LS_L1 may include first layer openings. The first layer opening may include a first sub-opening OPT_L1 and a second sub-opening OPT_R1. The first sub-opening OPT_L1 may be included in the first light transmission opening OPT_L illustrated in FIG. 7, and the second sub-opening OPT_R1 may be included in the second light transmission opening OPT_R illustrated in FIG. 7.

The first light transmitting lower film OPVX1 may be located on the first light blocking layer LS_L1 and the first medium layer OLD1. The first light transmitting lower film OPVX1 may cover the top surfaces and side surfaces of the plurality of first light blocking patterns of the first light blocking layer LS_L1. The first light transmitting lower film OPVX1 may transmit light emitted from the light emitting layer 172. The first light transmitting lower film OPVX1 may include a transparent organic material. In one embodiment, the thickness of the first light transmitting lower film OPVX1 may be approximately 2.5 µm to 5 µm, but is not limited thereto. Here, the thickness of the first light transmitting lower film OPVX1 refers to a distance in the third direction DR3 from the top surface to the bottom surface of the first light transmitting lower film OPVX1.

The first light transmitting lower film OPVX1 may be a lower film for preventing overflow of the first light transmitting film LT_L1 at the outer portion of the display panel 100. For example, the first light transmitting lower film OPVX1 may form a dam-like structure at the outer portion of the display panel 100 to prevent overflow of the first light transmitting film LT_L1.

The first light transmitting film LT_L1 may be located on the first light transmitting lower film OPVX1. The first light transmitting film LT_L1 may transmit the light emitted from the light emitting layer 172. The first light transmitting film LT_L1 may include a transparent organic material. In one embodiment, the thickness of the first light transmitting film LT_L1 may be approximately 5 µm to 20 µm, but is not limited thereto. Here, the thickness of the first light transmitting film LT_L1 refers to a distance in the third direction DR3 from the top surface to the bottom surface of the first light transmitting film LT_L1.

The second medium layer OLD2 may be located on the first light transmitting film LT_L1. The second medium layer OLD2 may include a transparent inorganic material. For example, the second medium layer OLD2 may include at least one of silicon oxide (SiOₓ), silicon nitride (SiNₓ), or silicon oxynitride (SiOₓN_{y}). In one embodiment, the second medium layer OLD2 may include silicon nitride (SiNₓ), and the thickness of the second medium layer OLD2 may be about 500 Å to 1000 Å, but is not limited thereto. Here, the thickness of the second medium layer OLD2 refers to a distance in the third direction DR3 from the top surface to the bottom surface of the second medium layer OLD2.

The second medium layer OLD2 may be located between the second light transmitting lower film OPVX2 and the organic film (e.g., the first light transmitting film LT_L1) to increase interfacial properties so that the second light transmitting lower film OPVX2 may be easily deposited on the organic film during the deposition process of the second light transmitting lower film OPVX2. For example, when the second light transmitting lower film OPVX2 is directly deposited on the organic film having interfacial properties different from those of the second light transmitting lower film OPVX2, deposition particles may not be easily deposited on the organic film. On the other hand, when the second medium layer OLD2 is located on the organic film, the deposition particles of the second light transmitting lower film OPVX2 may be easily deposited on the second medium layer OLD2.

The second light blocking layer LS_L2 may be located on the second medium layer OLD2. The second light blocking layer LS_L2 may absorb or block the light emitted from the light emitting layer 172. The second light blocking layer LS_L2 may include a light blocking organic material. In one embodiment, the thickness of the second light blocking layer LS_L2 may be approximately 1 µm to 2 µm, but is not limited thereto. Here, the thickness of the second light blocking layer LS_L2 refers to a distance in the third direction DR3 from the top surface to the bottom surface of the second light blocking layer LS_L2.

The second light blocking layer LS_L2 may include the plurality of second light blocking patterns. The plurality of second light blocking patterns may be spaced apart from each other in the first direction DR1 or the second direction DR2. The plurality of second light blocking patterns may constitute the central light blocking film LS_C, the first peripheral light blocking film LS_L, and the second peripheral light blocking film LS_R illustrated in FIG. 7.

The second light blocking layer LS_L2 may include second layer openings. The second layer opening may include a third sub-opening OPT_L2 and a fourth sub-opening OPT_R2. The third sub-opening OPT_L2 may be included in the first light transmission opening OPT_L illustrated in FIG. 7, and the fourth sub-opening OPT_R2 may be included in the second light transmission opening OPT_R illustrated in FIG. 7.

The second light transmitting lower film OPVX2 may be located on the second light blocking layer LS_L2 and the second medium layer OLD2. The second light transmitting lower film OPVX2 may cover the top surfaces and side surfaces of the plurality of second light blocking patterns of the second light blocking layer LS_L2. The second light transmitting lower film OPVX2 may transmit light emitted from the light emitting layer 172. The second light transmitting lower film OPVX2 may include a transparent organic material. In one embodiment, the thickness of the second light transmitting lower film OPVX2 may be approximately 2.5 µm to 5 µm, but is not limited thereto. Here, the thickness of the second light transmitting lower film OPVX2 refers to a distance in the third direction DR3 from the top surface to the bottom surface of the second light transmitting lower film OPVX2.

The second light transmitting lower film OPVX2 may be a lower film for preventing overflow of the second light transmitting film LT_L2 at the outer portion of the display panel 100. For example, the second light transmitting lower film OPVX2 may form a dam-like structure at the outer portion of the display panel 100 to prevent overflow of the second light transmitting film LT_L2.

The second light transmitting film LT_L2 may be located on the second light transmitting lower film OPVX2. The second light transmitting film LT_L2 may transmit the light emitted from the light emitting layer 172. The second light transmitting film LT_L2 may include a transparent organic material. In one embodiment, the thickness of the second light transmitting film LT_L2 may be approximately 5 µm to 20 µm, but is not limited thereto. Here, the thickness of the second light transmitting film LT_L2 refers to a distance in the third direction DR3 from the top surface to the bottom surface of the second light transmitting film LT_L2.

The third medium layer OLD3 may be located on the second light transmitting film LT_L2. The third medium layer OLD3 may include a transparent inorganic material. For example, the third medium layer OLD3 may include at least one of silicon oxide (SiOₓ), silicon nitride (SiNₓ), or silicon oxynitride (SiOₓN_{y}). In one embodiment, the third medium layer OLD3 may include silicon nitride (SiNₓ), and the thickness of the third medium layer OLD3 may be about 500 Å to 1000 Å, but is not limited thereto. Here, the thickness of the third medium layer OLD3 refers to a distance in the third direction DR3 from the top surface to the bottom surface of the third medium layer OLD3.

The third medium layer OLD3 may be located between the third light transmitting lower film OPVX3 and the organic film (e.g., the second light transmitting film LT_L2) to increase interfacial properties so that the third light transmitting lower film OPVX3 may be easily deposited on the organic film during the deposition process of the third light transmitting lower film OPVX3. For example, when the third light transmitting lower film OPVX3 is directly deposited on the organic film having interfacial properties different from those of the third light transmitting lower film OPVX3, deposition particles may not be easily deposited on the organic film. On the other hand, when the third medium layer OLD3 is located on the organic film, the deposition particles of the third light transmitting lower film OPVX3 may be easily deposited on the third medium layer OLD3.

The third light blocking layer LS_L3 may be located on the third medium layer OLD3. The third light blocking layer LS_L3 may absorb or block the light emitted from the light emitting layer 172. The third light blocking layer LS_L3 may include a light blocking organic material. In one embodiment, the thickness of the third light blocking layer LS_L3 may be approximately 1 µm to 2 µm, but is not limited thereto. Here, the thickness of the third light blocking layer LS_L3 refers to a distance in the third direction DR3 from the top surface to the bottom surface of the third light blocking layer LS_L3.

The third light blocking layer LS_L3 may include a plurality of third light blocking patterns. The plurality of third light blocking patterns may be spaced apart from each other in the first direction DR1 or the second direction DR2. The plurality of third light blocking patterns may constitute the central light blocking film LS_C, the first peripheral light blocking film LS_L, and the second peripheral light blocking film LS_R illustrated in FIG. 7.

The third light blocking layer LS_L3 may include third layer openings. The third layer opening may include a fifth sub-opening OPT_L3 and a sixth sub-opening OPT_R3. The fifth sub-opening OPT_L3 may be included in the first light transmission opening OPT_L illustrated in FIG. 7, and the sixth sub-opening OPT_R3 may be included in the second light transmission opening OPT_R illustrated in FIG. 7.

The third light transmitting lower film OPVX3 may be located on the third light blocking layer LS_L3 and the third medium layer OLD3. The third light transmitting lower film OPVX3 may cover the top surfaces and side surfaces of the plurality of third light blocking patterns of the third light blocking layer LS_L3. The third light transmitting lower film OPVX3 may transmit light emitted from the light emitting layer 172. The third light transmitting lower film OPVX3 may include a transparent organic material. In one embodiment, the thickness of the third light transmitting lower film OPVX3 may be approximately 2.5 µm to 5 µm, but is not limited thereto. Here, the thickness of the third light transmitting lower film OPVX3 refers to a distance in the third direction DR3 from the top surface to the bottom surface of the third light transmitting lower film OPVX3.

The third light transmitting lower film OPVX3 may be a lower film for preventing overflow of the third light transmitting film LT_L3 at the outer portion of the display panel 100. For example, the third light transmitting lower film OPVX3 may form a dam-like structure at the outer portion of the display panel 100 to prevent overflow of the third light transmitting film LT_L3.

The third light transmitting film LT_L3 may be located on the third light transmitting lower film OPVX3. The third light transmitting film LT_L3 may transmit light emitted from the light emitting layer 172. The third light transmitting film LT_L3 may include a transparent organic material. In one embodiment, the thickness of the third light transmitting film LT_L3 may be approximately 5 µm to 20 µm, but is not limited thereto. Here, the thickness of the third light transmitting film LT_L3 refers to a distance in the third direction DR3 from the top surface to the bottom surface of the third light transmitting film LT_L3.

The fourth medium layer OLD4 may be located on the third light transmitting film LT_L3. The fourth medium layer OLD4 may include a transparent inorganic material. For example, the fourth medium layer OLD4 may include at least one of silicon oxide (SiOₓ), silicon nitride (SiNₓ), or silicon oxynitride (SiOₓN_{y}). In one embodiment, the fourth medium layer OLD4 may include silicon nitride (SiNₓ), and the thickness of the fourth medium layer OLD4 may be about 500 Å to 1000 Å, but is not limited thereto. Here, the thickness of the fourth medium layer OLD4 refers to a distance in the third direction DR3 from the top surface to the bottom surface of the fourth medium layer OLD4.

The fourth medium layer OLD4 may be located between the overcoat layer OC and the organic film (e.g., the third light transmitting film LT_L3) to enhance the interface properties such that the overcoat layer OC may be easily deposited on the organic film during the deposition process of the overcoat layer OC. For example, when the overcoat layer OC is directly deposited on an organic film having different interface properties from the overcoat layer OC, the deposition particles may not be easily deposited on the organic film. On the other hand, when the fourth medium layer OLD4 is located on the organic film, the deposition particles of the overcoat layer OC may be easily deposited on the fourth medium layer OLD4.

The fourth light blocking layer LS_L4 may be located on the fourth medium layer OLD4. The fourth light blocking layer LS_L4 may absorb or block the light emitted from the light emitting layer 172. The fourth light blocking layer LS_L4 may include a light blocking organic material. In one embodiment, the thickness of the fourth light blocking layer LS_L4 may be approximately 1 µm to 2 µm, but is not limited thereto. Here, the thickness of the fourth light blocking layer LS_L4 refers to a distance in the third direction DR3 from the top surface to the bottom surface of the fourth light blocking layer LS_L4.

The fourth light blocking layer LS_L4 may include a plurality of fourth light blocking patterns. The plurality of fourth light blocking patterns may be spaced apart from each other in the first direction DR1 or the second direction DR2. The plurality of fourth light blocking patterns may constitute the central light blocking film LS_C, the first peripheral light blocking film LS_L, and the second peripheral light blocking film LS_R illustrated in FIG. 7.

The fourth light blocking layer LS_L4 may include fourth layer openings. The fourth layer opening may include a seventh sub-opening OPT_L4 and an eighth sub-opening OPT_R4. The seventh sub-opening OPT_L4 may be included in the first light transmission opening OPT_L illustrated in FIG. 7, and the eighth sub-opening OPT_R4 may be included in the second light transmission opening OPT_R illustrated in FIG. 7.

The overcoat layer OC may be located on the fourth light blocking layer LS_L4 and the medium layer OLD4. The overcoat layer OC may cover the top surfaces and side surfaces of the plurality of fourth light blocking patterns of the fourth light blocking layer LS_L4. The overcoat layer OC may transmit light emitted from the light emitting layer 172. The overcoat layer OC may include a transparent organic material. In one embodiment, the thickness of the overcoat layer OC may be approximately 2.5 µm to 5 µm, but is not limited thereto. Here, the thickness of the overcoat layer OC refers to a distance in the third direction DR3 from the top surface to the bottom surface of the third light transmitting film LT_L3.

In the drawing, the light blocking film LS is illustrated as including four light blocking layers, but is not limited thereto, and the number of light blocking layers included in the light blocking film LS may modified in various ways. Depending on the number of light blocking layers, the number of adjacent layers may also be modified.

Referring to FIGS. 7 to 9, the arrangement relationship between the emission area EA and the light blocking layer LS is described.

The first light transmission opening OPT_L of the light blocking layer LS may be located to be offset toward the other side of the first direction DR1 with respect to the first group area GEA1, and the second light transmission opening OPT_R of the light blocking layer LS may be located to be offset toward one side of the first direction DR1 with respect to the second group area GEA2. Here, the fact that the light transmission opening is located to be offset from the group area means that the center of the light transmission opening in the first direction DR1 is positioned on the other side (or one side) of the first direction DR1 from the center of the group area in the first direction DR1.

For example, the first sub-opening OPT_L1 of the first light blocking layer LS_L1, the third sub-opening OPT_L2 of the second light blocking layer LS_L2, the fifth sub-opening OPT_L3 of the third light blocking layer LS_L3, and the seventh sub-opening OPT_L4 of the fourth light blocking layer LS_L4 may be located to be offset toward the other side of the first direction DR1 from the first emission area EA1 of the first group area GEA1. Likewise, the second sub-opening OPT_R1 of the first light blocking layer LS_L1, the fourth sub-opening OPT_R2 of the second light blocking layer LS_L2, the sixth sub-opening OPT_R3 of the third light blocking layer LS_L3, and the eighth sub-opening OPT_R4 of the fourth light blocking layer LS_L4 may be located to be offset toward one side of the first direction DR1 from the fourth emission area EA4 of the second group area GEA2.

In addition, the degree to which the sub-openings of the first light transmission opening OPT_L of the light blocking layer LS are offset toward the other side of the first direction DR1 with respect to the first group area GEA1 may increase as they go toward the upper layers, and the degree to which the sub-openings of the second light transmission opening OPT_R of the light blocking layer LS are offset toward one side of the first direction DR1 with respect to the second group area GEA2 may increase as they go toward the upper layers. Here, the degree of offset becoming greater as it goes toward the upper layers means that the distance in the first direction DR1 between the center of the sub-opening in the first direction DR1 and the center of the group area in the first direction DR1 becomes greater as it goes toward the upper layers.

For example, the distance in the first direction DR1 between the center of the first sub-opening OPT_L1 of the first light blocking layer LS_L1 in the first direction DR1 and the center of the first emission area EA1 in the first direction DR1 may be less than the distance in the first direction DR1 between the center of the third sub-opening OPT_L2 of the second light blocking layer LS_L2 in the first direction DR1 and the center of the first emission area EA1 in the first direction DR1, the distance in the first direction DR1 between the center of the third sub-opening OPT_L2 of the second light blocking layer LS_L2 in the first direction DR1 and the center of the first emission area EA1 in the first direction DR1 may be less than the distance in the first direction DR1 between the center of the fifth sub-opening OPT_L3 of the third light blocking layer LS_L3 in the first direction DR1 and the center of the first emission area EA1 in the first direction DR1, and the distance in the first direction DR1 between the center of the fifth sub-opening OPT_L3 of the third light blocking layer LS_L3 in the first direction DR1 and the center of the first emission area EA1 in the first direction DR1 may be less than the distance in the first direction DR1 between the center of the seventh sub-opening OPT_L4 of the fourth light blocking layer LS_L4 in the first direction DR1 and the center of the first emission area EA1 in the first direction DR1. Likewise, the distance in the first direction DR1 between the center of the second sub-opening OPT_R1 of the first light blocking layer LS_L1 in the first direction DR1 and the center of the fourth emission area EA4 in the first direction DR1 may be less than the distance in the first direction DR1 between the center of the fourth sub-opening OPT_R2 of the second light blocking layer LS_L2 in the first direction DR1 and the center of the fourth emission area EA4 in the first direction DR1, the distance in the first direction DR1 between the center of the fourth sub-opening OPT_R2 of the second light blocking layer LS_L2 in the first direction DR1 and the center of the fourth emission area EA4 in the first direction DR1 may be less than the distance in the first direction DR1 between the center of the sixth sub-opening OPT_R3 of the third light blocking layer LS_L3 in the first direction DR1 and the center of the fourth emission area EA4 in the first direction DR1, and the distance in the first direction DR1 between the center of the sixth sub-opening OPT_R3 of the third light blocking layer LS_L3 in the first direction DR1 and the center of the fourth emission area EA4 in the first direction DR1 may be less than the distance in the first direction DR1 between the center of the eighth sub-opening OPT_R4 of the fourth light blocking layer LS_L4 in the first direction DR1 and the center of the fourth emission area EA4 in the first direction DR1.

Accordingly, a first straight line L1 connecting the respective centers of the first sub-opening OPT_L1 of the first light blocking layer LS_L1, the third sub-opening OPT_L2 of the second light blocking layer LS_L2, the fifth sub-opening OPT_L3 of the third light blocking layer LS_L3, and the seventh sub-opening OPT_L4 of the fourth light blocking layer LS_L4 may be inclined at a selected angle (e.g., to the left side in the drawing) with respect to the third direction DR3. Likewise, a second straight line L2 connecting the respective centers of the second sub-opening OPT_R1 of the first light blocking layer LS_L1, the fourth sub-opening OPT_R2 of the second light blocking layer LS_L2, the sixth sub-opening OPT_R3 of the third light blocking layer LS_L3, and the eighth sub-opening OPT_R4 of the fourth light blocking layer LS_L4 may be inclined at a selected angle (e.g., to the right side in the drawing) with respect to the third direction DR3.

That is, the first emission area EA1, the first sub-opening OPT_L1, the third sub-opening OPT_L2, the fifth sub-opening OPT_L3, and the seventh sub-opening OPT_L4 may be located to be shifted in a diagonal direction that is obliquely inclined toward one side with respect to the third direction DR3 as they go toward the upper layers. Likewise, the fourth emission area EA4, the second sub-opening OPT_R1, the fourth sub-opening OPT_R2, the sixth sub-opening OPT_R3, and the eighth sub-opening OPT_R4 may be located to be shifted in a diagonal direction that is obliquely inclined toward the other side with respect to the third direction DR3 as they go toward the upper layers.

In some embodiments, the center of the first emission area EA1 in the first direction DR1 may also be positioned on the first straight line L1, and the center of the fourth emission area EA4 in the first direction DR1 may also be positioned on the second straight line L2, but the present disclosure is not limited thereto.

One end of the first light transmission opening OPT_L in the first direction DR1 may be located to be offset toward the other side of the first direction DR1 from one end of the first group area GEA1 in the first direction DR1, and the other end of the first light transmission opening OPT_L in the first direction DR1 may be located to be offset toward the other side of the first direction DR1 from the other end of the first group area GEA1 in the first direction DR1. Likewise, the other end of the second light transmission opening OPT_R in the first direction DR1 may be located to be offset toward one side of the first direction DR1 from the other end of the second group area GEA2 in the first direction DR1, and one end of the second light transmission opening OPT_R in the first direction DR1 may be located to be offset toward one side of the first direction DR1 from one end of the second group area GEA2 in the first direction DR1.

For example, a third straight line L3 connecting respective one ends of the first sub-opening OPT_L1, the third sub-opening OPT_L3, the fifth sub-opening OPT_L5, and the seventh sub-opening OPT_L7 in the first direction DR1 may be inclined at a selected angle (e.g., to the left side in the drawing) with respect to the third direction DR3, and a fourth straight line L4 connecting the respective other ends of the first sub-opening OPT_L1, the third sub-opening OPT_L3, the fifth sub-opening OPT_L5, and the seventh sub-opening OPT_L7 in the first direction DR1 may be inclined at a selected angle (e.g., to the left side in the drawing) with respect to the third direction DR3. Likewise, a fifth straight line L5 connecting the respective other ends of the second sub-opening OPT_R1, the fourth sub-opening OPT_R3, the sixth sub-opening OPT_R5, and the eighth sub-opening OPT_R7 in the first direction DR1 may be inclined at a selected angle (e.g., to the right side in the drawing) with respect to the third direction DR3, and a sixth straight line L6 connecting respective one ends of the second sub-opening OPT_R1, the fourth sub-opening OPT_R3, the sixth sub-opening OPT_R5, and the eighth sub-opening OPT_R7 in the first direction DR1 may be inclined at a selected angle (e.g., to the right side in the drawing) with respect to the third direction DR3.

In some embodiments, one end of the first emission area EA1 in the first direction DR1 may also be positioned on the third straight line L3, the other end of the first emission area EA1 in the first direction DR1 may also be positioned on the fourth straight line L4, the other end of the fourth emission area EA4 in the first direction DR1 may also be positioned on the fifth straight line L5, and one end of the fourth emission area EA4 in the first direction DR1 may also be positioned on the sixth straight line L6, but the present disclosure is not limited thereto.

The absolute values of the inclinations of the first straight line L1 and the second straight line L2 with respect to the third direction DR3 may be substantially equal to each other, the absolute values of the inclinations of the third straight line L3 and the fifth straight line L5 with respect to the third direction DR3 may be substantially equal to each other, and the absolute values of the inclinations of the fourth straight line L4 and the sixth straight line L6 with respect to the third direction DR3 may be substantially equal to each other. The absolute value of an inclination of a line L1 with respect to a line in the direction of DR3 may be measured by the angle formed between the line L1 and the line in the direction of D3. Similarly, the angle formed between the line L2 and line in the direction of D3 can be measured. Therefore, L2 may be inclined from the direction of D3 by an angle substantially equal to the angle between L1 and the line in the direction of D3, namely. When the absolute values of the two angles are substantially the same.

Here, the absolute values of the inclinations of the two straight lines with respect to the third direction DR3 being substantially equal means that the magnitude of the angle that one straight line makes with the third direction DR3 is equal to the magnitude of the angle that the other straight line makes with the third direction DR3. That is, when the magnitudes of the degree to which the two straight lines are inclined with respect to the third direction DR3 are the same, regardless of whether the two straight lines are inclined toward one side of the first direction DR1 or inclined toward the other side of the first direction DR1 with respect to the third direction DR3, the absolute values of the inclinations of the two straight lines with respect to the third direction DR3 may be regarded as being substantially the same.

For example, as illustrated in FIG. 9, the first straight line L1 may be inclined toward the other side of the first direction DR1 with respect to the third direction DR3, and the second straight line L2 may be inclined toward one side of the first direction DR1 with respect to the third direction DR3. Regardless, the degree to which the first straight line L1 is inclined with respect to the third direction DR3 may be the same as the degree to which the second straight line L2 is inclined with respect to the third direction DR3, and in this case, the absolute values of the inclinations of the first straight line L1 and the second straight line L2 with respect to the third direction DR3 may be regarded as being substantially equal to each other.

In other words, when an imaginary line extending in a direction perpendicular to the display surface of the display device 10 is referred to as a normal line, each of the first straight line L1 and the second straight line L2 may have the same angle with respect to the normal line, each of the third straight line L3 and the fifth straight line L5 may have the same angle with respect to the normal line, and each of the fourth straight line L4 and the sixth straight line L6 may have the same angle with respect to the normal line.

The inclination of the third straight line L3 with respect to the third direction DR3 and the inclination of the fifth straight line L5 with respect to the third direction DR3 may be greater than the inclination of the first straight line L1 with respect to the third direction DR3 and the inclination of the second straight line L2 with respect to the third direction DR3, and the inclination of the first straight line L1 with respect to the third direction DR3 and the inclination of the second straight line L2 with respect to the third direction DR3 may be greater than the inclination of the fourth straight line L4 with respect to the third direction DR3 and the inclination of the sixth straight line L6 with respect to the third direction DR3.

In some embodiments, an angle θL_1a formed between the extended straight line in the third direction DR3 and the third straight line L3 while one end of the first sub-opening OPT_L1 in the first direction DR1 is set as an intersection, an angle θL_2a formed between the extended straight line in the third direction DR3 and the third straight line L3 while one end of the third sub-opening OPT_L2 in the first direction DR1 is set as an intersection, an angle θL_3a formed between the extended straight line in the third direction DR3 and the third straight line L3 while one end of the fifth sub-opening OPT_L3 in the first direction DR1 is set as an intersection, and an angle θL_4a formed between the extended straight line in the third direction DR3 and the third straight line L3 while one end of the seventh sub-opening OPT_L4 in the first direction DR1 is set as an intersection may be substantially equal to each other.

Likewise, in some embodiments, an angle θL_1b formed between the extended straight line in the third direction DR3 and the fourth straight line L4 while the other end of the first sub-opening OPT_L1 in the first direction DR1 is set as an intersection, an angle θL_2b formed between the extended straight line in the third direction DR3 and the fourth straight line L4 while the other end of the third sub-opening OPT_L2 in the first direction DR1 is set as an intersection, an angle θL_3b formed between the extended straight line in the third direction DR3 and the fourth straight line L4 while the other end of the fifth sub-opening OPT_L3 in the first direction DR1 is set as an intersection, and an angle θL_4b formed between the extended straight line in the third direction DR3 and the fourth straight line L4 while the other end of the seventh sub-opening OPT_L4 in the first direction DR1 is set as an intersection may be substantially equal to each other.

In some embodiments, an angle θR_1a formed between the extended straight line in the third direction DR3 and the fifth straight line L5 while the other end of the second sub-opening OPT_R1 in the first direction DR1 is set as an intersection, an angle θR_2a formed between the extended straight line in the third direction DR3 and the fifth straight line L5 while the other end of the fourth sub-opening OPT_R2 in the first direction DR1 is set as an intersection, an angle θR_3a formed between the extended straight line in the third direction DR3 and the fifth straight line L5 while the other end of the sixth sub-opening OPT_R3 in the first direction DR1 is set as an intersection, and an angle θR_4a formed between the extended straight line in the third direction DR3 and the fifth straight line L5 while the other end of the eighth sub-opening OPT_R4 in the first direction DR1 is set as an intersection may be substantially equal to each other.

Likewise, in some embodiments, an angle θR_1b formed between the extended straight line in the third direction DR3 and the sixth straight line L6 while one end of the second sub-opening OPT_R1 in the first direction DR1 is set as an intersection, an angle θR_2b formed between the extended straight line in the third direction DR3 and the sixth straight line L6 while one end of the fourth sub-opening OPT_R2 in the first direction DR1 is set as an intersection, an angle θR_3b formed between the extended straight line in the third direction DR3 and the sixth straight line L6 while one end of the sixth sub-opening OPT_R3 in the first direction DR1 is set as an intersection, and an angle θR_4b formed between the extended straight line in the third direction DR3 and the sixth straight line L6 while one end of the eighth sub-opening OPT_R4 in the first direction DR1 is set as an intersection may be substantially equal to each other.

The width of the first light transmission opening OPT_L and the width of the second light transmission opening OPT_R may be substantially equal to each other. For example, a width WL_1 of the first sub-opening OPT_L1 and a width WR_1 of the second sub-opening OPT_R1 may be substantially equal to each other, a width WL_2 of the third sub-opening OPT_L2 and a width WR_2 of the fourth sub-opening OPT_R2 may be substantially equal to each other, a width WL_3 of the fifth sub-opening OPT_L3 and a width WR_3 of the sixth sub-opening OPT_R3 may be substantially equal to each other, and a width WL_4 of the seventh sub-opening OPT_L4 and a width WR_4 of the eighth sub-opening OPT_R4 may be substantially equal to each other.

The width of the sub-opening of the light blocking film LS may become less as it goes toward the upper layers. For example, the width WL_1 of the first sub-opening OPT_L1 and the width WR_1 of the second sub-opening OPT_R1 may be greater than the width WL_2 of the third sub-opening OPT_L2 and the width WR_2 of the fourth sub-opening OPT_R2, the width WL_2 of the third sub-opening OPT_L2 and the width WR_2 of the fourth sub-opening OPT_R2 may be greater than the width WL_3 of the fifth sub-opening OPT_L3 and the width WR_3 of the sixth sub-opening OPT_R3, and the width WL_3 of the fifth sub-opening OPT_L3 and the width WR_3 of the sixth sub-opening OPT_R3 may be greater than the width WL_4 of the seventh sub-opening OPT_L4 and the width WR_4 of the eighth sub-opening OPT_R4.

The width of the portion in the first direction DR1 where the central light blocking film LS_C overlaps the first group area GEA1 may be substantially the same as the width of the portion in the first direction DR1 where the central light blocking film LS_C overlaps the second group area GEA2. For example, a width PL_1 of the portion in the first direction DR1 where the central light blocking film LS_C located in the first light blocking layer LS_L1 overlaps the first emission area EA1 may be substantially the same as a width PR_1 of the portion in the first direction DR1 where the central light blocking film LS_C located in the first light blocking layer LS_L1 overlaps the fourth emission area EA4, a width PL_2 of the portion in the first direction DR1 where the central light blocking film LS_C located in the second light blocking layer LS_L2 overlaps the first emission area EA1 may be substantially the same as a width PR_2 of the portion in the first direction DR1 where the central light blocking film LS_C located in the second light blocking layer LS_L2 overlaps the fourth emission area EA4, a width PL_3 of the portion in the first direction DR1 where the central light blocking film LS_C located in the third light blocking layer LS_L3 overlaps the first emission area EA1 may be substantially the same as a width PR_3 of the portion in the first direction DR1 where the central light blocking film LS_C located in the third light blocking layer LS_L3 overlaps the fourth emission area EA4, and a width PL_4 of the portion in the first direction DR1 where the central light blocking film LS_C located in the fourth light emitting layer LS_L4 overlaps the first emission area EA1 may be substantially the same as a width PR_4 of the portion in the first direction DR1 where the central light blocking film LS_C located in the fourth light emitting layer LS_L4 overlaps the fourth emission area EA4.

The width of the portion in the first direction DR1 where the central light blocking film LS_C overlaps the emission area EA may increase as it goes toward the upper layers. For example, the width PL_1 of the portion in the first direction DR1 where the central light blocking film LS_C located in the first light blocking layer LS_L1 overlaps the first emission area EA1 may be less than the width PL_2 of the portion in the first direction DR1 where the central light blocking film LS_C located in the second light blocking layer LS_L2 overlaps the first emission area EA1, the width PL_2 of the portion in the first direction DR1 where the central light blocking film LS_C located in the second light blocking layer LS_L2 overlaps the first emission area EA1 may be less than the width PL_3 of the portion in the first direction DR1 where the central light blocking film LS_C located in the third light blocking layer LS_L3 overlaps the first emission area EA1, and the width PL_3 of the portion in the first direction DR1 where the central light blocking film LS_C located in the third light blocking layer LS_L3 overlaps the first emission area EA1 may be less than the width PL_4 of the portion in the first direction DR1 where the central light blocking film LS_C located in the fourth light blocking layer LS_L4 overlaps the first emission area EA1. Likewise, the width PR_1 of the portion in the first direction DR1 where the central light blocking film LS_C located in the first light blocking layer LS_L1 overlaps the fourth emission area EA4 may be less than the width PR_2 of the portion in the first direction DR1 where the central light blocking film LS_C located in the second light blocking layer LS_L2 overlaps the fourth emission area EA4, the width PR_2 of the portion in the first direction DR1 where the central light blocking film LS_C located in the second light blocking layer LS_L2 overlaps the fourth emission area EA4 may be less than the width PR_3 of the portion in the first direction DR1 where the central light blocking film LS_C located in the third light blocking layer LS_L3 overlaps the fourth emission area EA4, and the width PR_3 of the portion in the first direction DR1 where the central light blocking film LS_C located in the third light blocking layer LS_L3 overlaps the fourth emission area EA4 may be less than the width PR_4 of the portion in the first direction DR1 where the central light blocking film LS_C located in the fourth light blocking layer LS_L4 overlaps the fourth emission area EA4.

The separation distance in the first direction DR1 between the first peripheral light blocking film LS_L and the first group area GEA1 may be substantially equal to the separation distance in the first direction DR1 between the second peripheral light blocking film LS_R and the second group area GEA2. For example, a separation distance DL_1 in the first direction DR1 between the first peripheral light blocking film LS_L located in the first light blocking layer LS_L1 and the first emission area EA1 may be substantially the same as a separation distance DR_1 in the first direction DR1 between the second peripheral light blocking film LS_R located in the first light blocking layer LS_L1 and the fourth emission area EA4, a separation distance DL_2 in the first direction DR1 between the first peripheral light blocking film LS_L located in the second light blocking layer LS_L2 and the first emission area EA1 may be substantially the same as a separation distance DR_2 in the first direction DR1 between the second peripheral light blocking film LS_R located in the second light blocking layer LS_L2 and the fourth emission area EA4, a separation distance DL_3 in the first direction DR1 between the first peripheral light blocking film LS_L located in the third light blocking layer LS_L3 and the first emission area EA1 may be substantially the same as a separation distance DR_3 in the first direction DR1 between the second peripheral light blocking film LS_R located in the third light blocking layer LS_L3 and the fourth emission area EA4, and a separation distance DL_4 in the first direction DR1 between the first peripheral light blocking film LS_L located in the fourth light blocking layer LS_L4 and the first emission area EA1 may be substantially the same as a separation distance DR_4 in the first direction DR1 between the second peripheral light blocking film LS_R located in the fourth light blocking layer LS_L4 and the fourth emission area EA4.

The separation distance in the first direction DR1 between the first peripheral light blocking film LS_L and the first group area GEA1 and the separation distance in the first direction DR1 between the second peripheral light blocking film LS_R and the second group area GEA2 may increase as they go toward the upper layers. For example, the separation distance DL_1 in the first direction DR1 between the first peripheral light blocking film LS_L located in the first light blocking layer LS_L1 and the first emission area EA1 may be less than the separation distance DL_2 in the first direction DR1 between the first peripheral light blocking film LS_L located in the second light blocking layer LS_L2 and the first emission area EA1, the separation distance DL_2 in the first direction DR1 between the first peripheral light blocking film LS_L located in the second light blocking layer LS_L2 and the first emission area EA1 may be less than the separation distance DL_3 in the first direction DR1 between the first peripheral light blocking film LS_L located in the third light blocking layer LS_L3 and the first emission area EA1, and the separation distance DL_3 in the first direction DR1 between the first peripheral light blocking film LS_L located in the third light blocking layer LS_L3 and the first emission area EA1 may be less than the separation distance DL_4 in the first direction DR1 between the first peripheral light blocking film LS_L located in the fourth light blocking layer LS_L4 and the first emission area EA1. Likewise, the separation distance DR_1 in the first direction DR1 between the second peripheral light blocking film LS_R located in the first light blocking layer LS_L1 and the fourth emission area EA4 may be less than the separation distance DR_2 in the first direction DR1 between the second peripheral light blocking film LS_R located in the second light blocking layer LS_L2 and the fourth emission area EA4, the separation distance DR_2 in the first direction DR1 between the second peripheral light blocking film LS_R located in the second light blocking layer LS_L2 and the fourth emission area EA4 may be less than the separation distance DR_3 in the first direction DR1 between the second peripheral light blocking film LS_R located in the third light blocking layer LS_L3 and the fourth emission area EA4, and the separation distance DR_3 in the first direction DR1 between the second peripheral light blocking film LS_R located in the third light blocking layer LS_L3 and the fourth emission area EA4 may be less than the separation distance DR_4 in the first direction DR1 between the second peripheral light blocking film LS_R located in the fourth light blocking layer LS_L4 and the fourth emission area EA4.

In the display device 10 according to the present embodiment, the first image light LGT3 emitted from the first to third emission areas EA1, EA2, and EA3 (or the first to third light emitting elements 170_1a, 170_2a, and 170_3a of the first light emitting element group 170_a) of the first group area GEA1 and the second image light LGT4 emitted from the fourth to sixth emission areas EA4, EA5, and EA6 (or the fourth to sixth light emitting elements 170_1b, 170_2b, and 170_3b of the second light emitting element group 170_b) of the second group area GEA2 may display the first image IMG1 and the second image IMG2 that are different from each other, respectively. Accordingly, the driver PS1 and the passenger PS2 may watch different images. Such a display device 10 may be referred to as a veil view display, a dual view display, or a split view display.

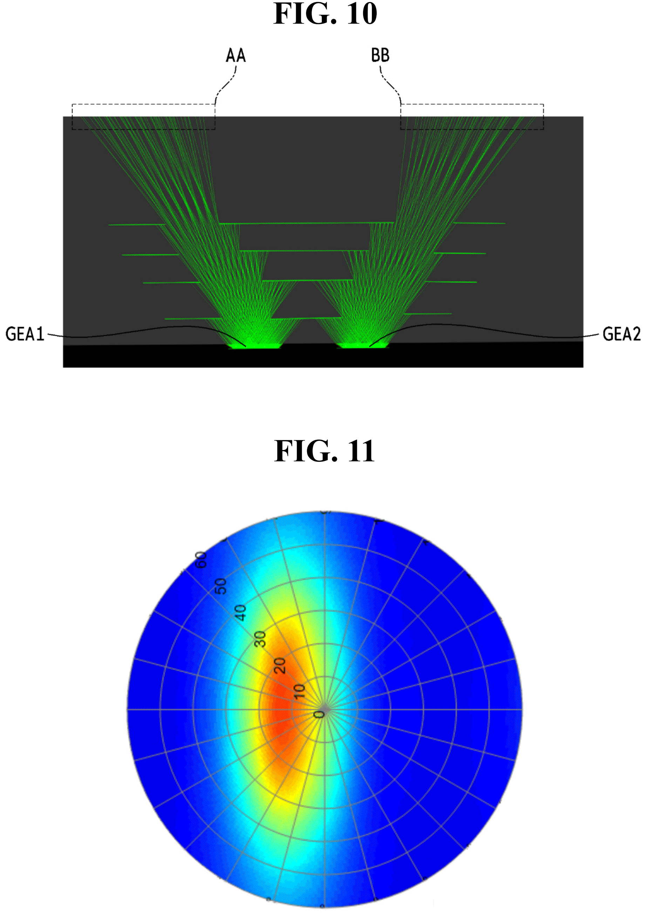

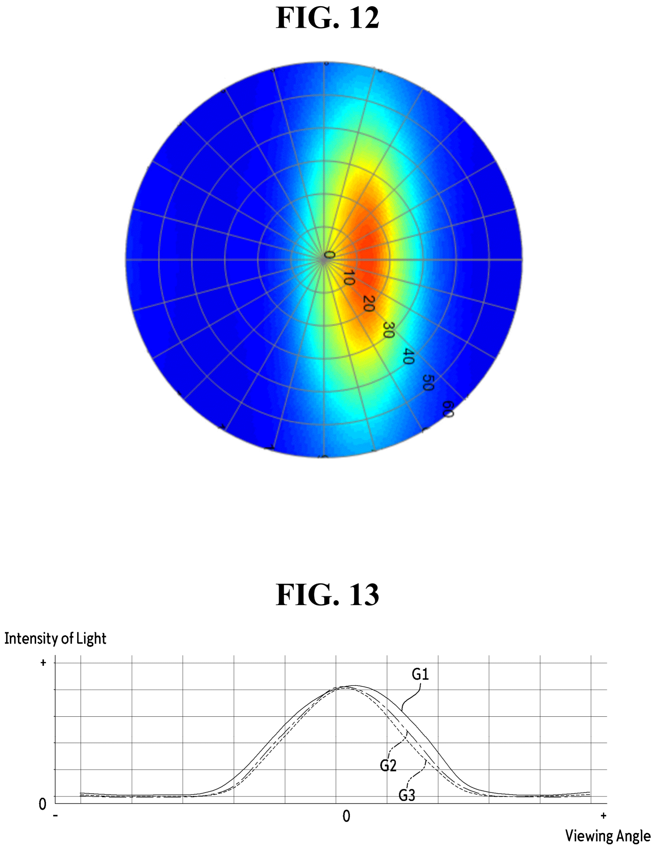

FIG. 10 is a simulation photograph showing a movement path of light in the display device according to one embodiment. FIG. 11 is a radial light intensity distribution diagram illustrating the light emission pattern of the first light emitting element group located in the first group area. FIG. 12 is a radial light intensity distribution diagram illustrating the light emission pattern of the second light emitting element group located in the second group area.

Referring to FIGS. 10 to 12 in addition to FIGS. 5 to 9, light emitted from the first group area GEA1 may be incident toward area AA positioned on the left side in the drawing, and light emitted from the second group area GEA2 may be incident toward area BB positioned on the right side in the drawing.

As illustrated in FIG. 11, light emitted from the first group area GEA1 may be concentrated on the left side of the radial light intensity distribution and exhibit high intensity. As illustrated in FIG. 12, light emitted from the second group area GEA2 may be concentrated on the right side of the radial light intensity distribution and exhibit high intensity.

The light emitted from the first group area GEA1 may be the first image light LGT3 described with reference to FIGS. 5 and 6, and the light emitted from the second group area GEA2 may be the second image light LGT4 described with reference to FIGS. 5 and 6.

In this way, in the display device 10 according to the present embodiment, the first image light LGT3 emitted from the first group area GEA1 and the second image light LGT4 emitted from the second group area GEA2 may display the first image IMG1 and the second image IMG2 in different areas (area AA and area BB), respectively. Accordingly, the driver PS1 positioned in area AA and the passenger PS2 positioned in area BB may watch different images.

Hereinafter, other embodiments of the display device according to one embodiment will be described. In the following embodiments, description of the same components as those of the above-described embodiment, which are denoted by like reference numerals, will be omitted or simplified, and differences will be mainly described.

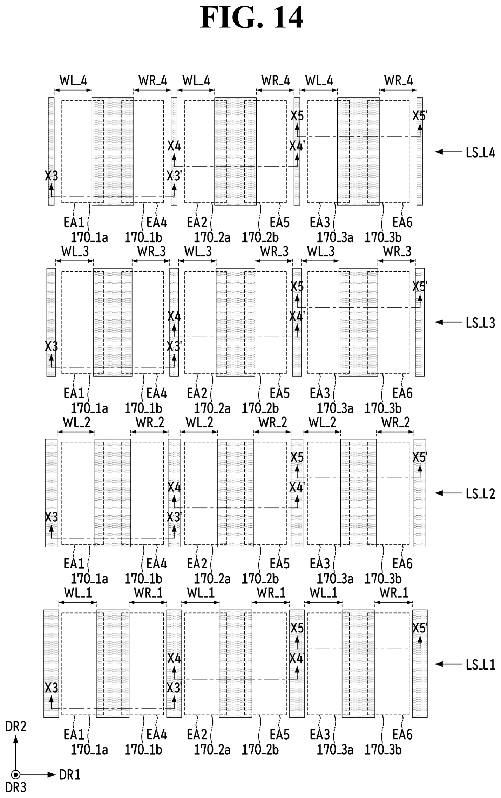

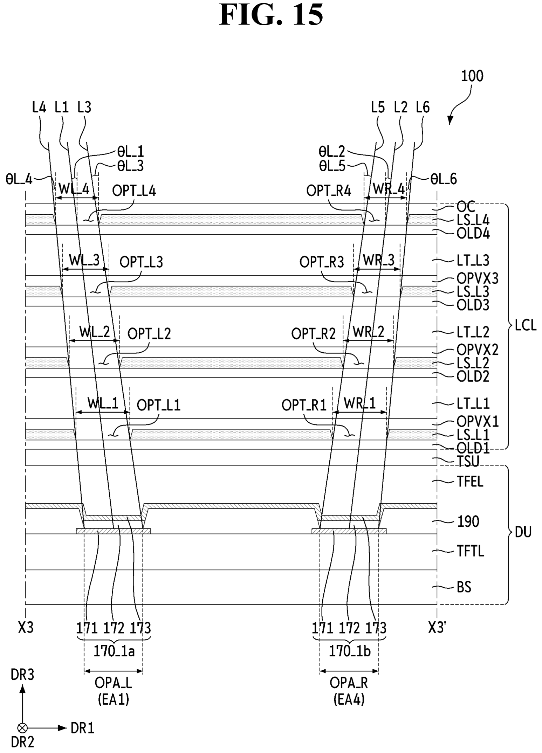

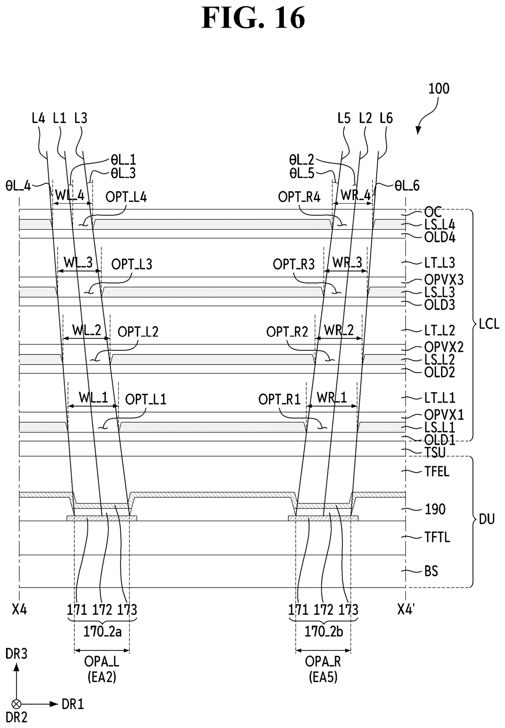

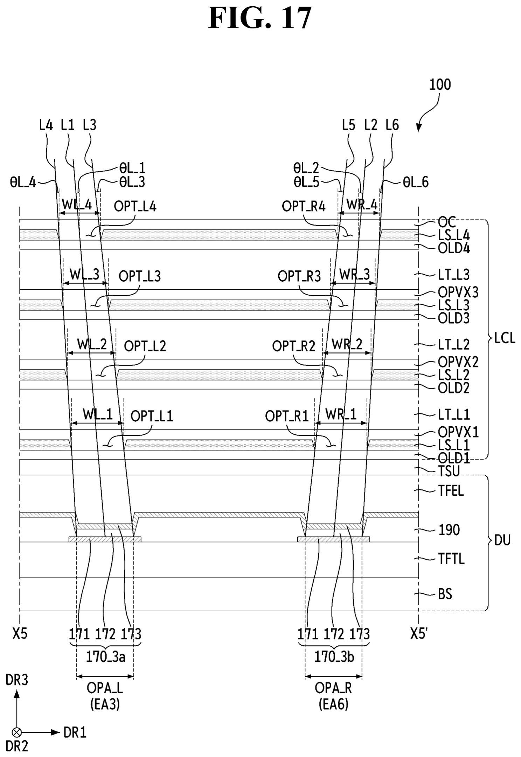

FIG. 13 is a graph illustrating the light intensity by color according to the viewing angle. FIG. 14 is a schematic diagram illustrating the planar arrangement of an emission area and a light control layer of a display device according to another embodiment, divided into layers. FIG. 15 is a cross-sectional view taken along line X3-X3' of FIG. 14. FIG. 16 is a cross-sectional view taken along line X4-X4' of FIG. 14. FIG. 17 is a cross-sectional view taken along line X5-X5' of FIG. 14.

Referring to FIGS. 13 to 17, the display device 10 according to the present embodiment is different from the display device 10 according to one embodiment described with reference to FIG. 7 and the like in that an angle at which light travels within the display panel is different according to the wavelength of the light emitted by each of the emission areas EA.

More specifically, the graphs in FIG. 13 are graphs illustrating the light intensity by color according to the viewing angle when the sub-openings of the light control layer LCL are not located obliquely with respect to the emission area EA and the centers of the sub-openings and the center of the emission area EA are located such that they completely coincide in the third direction DR3.

For example, unlike the display device 10 according to one embodiment described above with reference to FIG. 9, the graphs of FIG. 13 are graphs measured in the display device 10 in which the respective centers of the emission area EA, the first layer opening of the first light blocking layer LS_L1, the second layer opening of the second light blocking layer LS_L2, the third layer opening of the third light blocking layer LS_L3, and the fourth layer opening of the fourth light blocking layer LS_L4 are located to completely coincide in the third direction DR3.

The first graph G1 illustrates the intensity of light emitted from the emission area EA that emits red light according to the viewing angle, the second graph G2 illustrates the intensity of light emitted from the emission area EA that emits green light according to the viewing angle, and the third graph G3 illustrates the intensity of light emitted from the emission area EA that emits blue light according to the viewing angle.

As illustrated in FIG. 13, the viewing angle distribution of the first graph G1 is greater than the viewing angle distribution of the second graph G2, and the viewing angle distribution of the second graph G2 is greater than the viewing angle distribution of the third graph G3.

This phenomenon occurs because, when light emitted from the emission area EA passes through the medium layer, the light transmitting lower film, the light transmitting film, and the overcoat layer and is emitted to the outside (e.g., the air layer), the refractive index differs and the wavelength dispersion differs according to the wavelength.

That is, red light with a relatively long wavelength has a large dispersion as in the first graph G1, green light with a relatively medium wavelength has a medium dispersion as in the second graph G2, and blue light with a relatively short wavelength has a small dispersion as in the third graph G3.

Accordingly, the display device 10 according to the present embodiment may have an arrangement that allows the angle at which light travels within the display panel 100 to be differently formed such that the angle of the final light emitted to the outside is formed to be the same for each wavelength. For example, red light with high dispersion may be made to travel more obliquely within the display panel 100, green light with medium dispersion may be made to travel moderately obliquely within the display panel 100, and blue light with low dispersion may be made to travel less obliquely within the display panel 100.

Specifically, as illustrated in FIGS. 14 to 17, the inclination of each of the first to sixth straight lines L1 to L6 may be different for each of the emission areas EA that emits light of a different wavelength.

For example, the first straight line L1 corresponding to each of the first to third emission areas EA1, EA2, and EA3 may be inclined by a first traveling angle θL_1 with respect to the third direction DR3. At this time, the first traveling angle θL_1 corresponding to the first emission area EA1 may be greater than the first traveling angle θL_1 corresponding to the second emission area EA2, and the first traveling angle θL_1 corresponding to the second emission area EA2 may be greater than the first traveling angle θL_1 corresponding to the third emission area EA3. Likewise, the second straight line L2 corresponding to each of the fourth to sixth emission areas EA4, EA5, and EA6 may be inclined by a second traveling angle θL_2 with respect to the third direction DR3. At this time, the second traveling angle θL_2 corresponding to the fourth emission area EA4 may be greater than the second traveling angle θL_2 corresponding to the fifth emission area EA5, and the second traveling angle θL_2 corresponding to the fifth emission area EA5 may be greater than the second traveling angle θL_2 corresponding to the sixth emission area EA6.

In some embodiments, the first traveling angle θL_1 corresponding to the first emission area EA1 and the second traveling angle θL_2 corresponding to the fourth emission area EA4 may be equal to each other, the first traveling angle θL_1 corresponding to the second emission area EA2 and the second traveling angle θL_2 corresponding to the fifth emission area EA5 may be equal to each other, and the first traveling angle θL_1 corresponding to the third emission area EA3 and the second traveling angle θL_2 corresponding to the sixth emission area EA6 may be equal to each other.

Additionally, the third straight line L3 corresponding to each of the first to third emission areas EA1, EA2, and EA3 may be inclined by a third traveling angle θL_3 with respect to the third direction DR3. At this time, the third traveling angle θL_3 corresponding to the first emission area EA1 may be greater than the third traveling angle θL_3 corresponding to the second emission area EA2, and the third traveling angle θL_3 corresponding to the second emission area EA2 may be greater than the third traveling angle θL_3 corresponding to the third emission area EA3. Likewise, the fifth straight line L5 corresponding to each of the fourth to sixth emission areas EA4, EA5, and EA6 may be inclined by a fifth traveling angle θL_5 with respect to the third direction DR3. At this time, the fifth traveling angle θL_5 corresponding to the fourth emission area EA4 may be greater than the fifth traveling angle θL_5 corresponding to the fifth emission area EA5, and the fifth traveling angle θL_5 corresponding to the fifth emission area EA5 may be greater than the fifth traveling angle θL_5 corresponding to the sixth emission area EA6.

In some embodiments, the third traveling angle θL_3 corresponding to the first emission area EA1 and the fifth traveling angle θL_5 corresponding to the fourth emission area EA4 may be equal to each other, the third traveling angle θL_3 corresponding to the second emission area EA2 and the fifth traveling angle θL_5 corresponding to the fifth emission area EA5 may be equal to each other, and the third traveling angle θL_3 corresponding to the third emission area EA3 and the fifth traveling angle θL_5 corresponding to the sixth emission area EA6 may be equal to each other.

Additionally, the fourth straight line L4 corresponding to each of the first to third emission areas EA1, EA2, and EA3 may be inclined by a fourth traveling angle θL_4 with respect to the third direction DR3. At this time, the fourth traveling angle θL_4 corresponding to the first emission area EA1 may be greater than the fourth traveling angle θL_4 corresponding to the second emission area EA2, and the fourth traveling angle θL_4 corresponding to the second emission area EA2 may be greater than the fourth traveling angle θL_4 corresponding to the third emission area EA3. Likewise, the sixth straight line L6 corresponding to each of the fourth to sixth emission areas EA4, EA5, and EA6 may be inclined by a sixth traveling angle θL_6 with respect to the third direction DR3. At this time, the sixth traveling angle θL_6 corresponding to the fourth emission area EA4 may be greater than the sixth traveling angle θL_6 corresponding to the fifth emission area EA5, and the sixth traveling angle θL_6 corresponding to the fifth emission area EA5 may be greater than the sixth traveling angle θL_6 corresponding to the sixth emission area EA6.

In some embodiments, the fourth traveling angle θL_4 corresponding to the first emission area EA1 and the sixth traveling angle θL_6 corresponding to the fourth emission area EA4 may be equal to each other, the fourth traveling angle θL_4 corresponding to the second emission area EA2 and the sixth traveling angle θL_6 corresponding to the fifth emission area EA5 may be equal to each other, and the fourth traveling angle θL_4 corresponding to the third emission area EA3 and the sixth traveling angle θL_6 corresponding to the sixth emission area EA6 may be equal to each other.

In some embodiments, the width WL_1 of the first sub-opening OPT_L1, the width WL_2 of the third sub-opening OPT_L2, the width WL_3 of the fifth sub-opening OPT_L3, and the width WL_4 of the seventh sub-opening OPT_L4, which correspond to the first emission area EA1, may be less than the width WL_1 of the first sub-opening OPT_L1, the width WL_2 of the third sub-opening OPT_L2, the width WL_3 of the fifth sub-opening OPT_L3, and the width WL_4 of the seventh sub-opening OPT_L4, which correspond to the second emission area EA2, respectively, and the width WL_1 of the first sub-opening OPT_L1, the width WL_2 of the third sub-opening OPT_L2, the width WL_3 of the fifth sub-opening OPT_L3, and the width WL_4 of the seventh sub-opening OPT_L4, which correspond to the second emission area EA2, may be less than the width WL_1 of the first sub-opening OPT_L1, the width WL_2 of the third sub-opening OPT_L2, the width WL_3 of the fifth sub-opening OPT_L3, and the width WL_4 of the seventh sub-opening OPT_L4, which correspond to the third emission area EA3, respectively. Likewise, the width WR_1 of the second sub-opening OPT_R1, the width WR_2 of the fourth sub-opening OPT_R2, the width WR_3 of the sixth sub-opening OPT_R3, and the width WR_4 of the eighth sub-opening OPT_R4, which correspond to the fourth emission area EA4, may be less than the width WR_1 of the second sub-opening OPT_R1, the width WR_2 of the fourth sub-opening OPT_R2, the width WR_3 of the sixth sub-opening OPT_R3, and the width WR_4 of the eighth sub-opening OPT_R4, which correspond to the fifth emission area EA5, respectively, and the width WR_1 of the second sub-opening OPT_R1, the width WR_2 of the fourth sub-opening OPT_R2, the width WR_3 of the sixth sub-opening OPT_R3, and the width WR_4 of the eighth sub-opening OPT_R4, which correspond to the fifth emission area EA5, may be less than the width WR_1 of the second sub-opening OPT_R1, the width WR_2 of the fourth sub-opening OPT_R2, the width WR_3 of the sixth sub-opening OPT_R3, and the width WR_4 of the eighth sub-opening OPT_R4, which correspond to the sixth emission area EA6, respectively.

The display device 10 according to the present embodiment may cause light to be emitted at a constant angle regardless of the wavelength of the light by changing the angle at which the emission area EA and the sub-openings of the light blocking layer LS are obliquely located depending on the wavelength of the light emitted from the emission area EA.

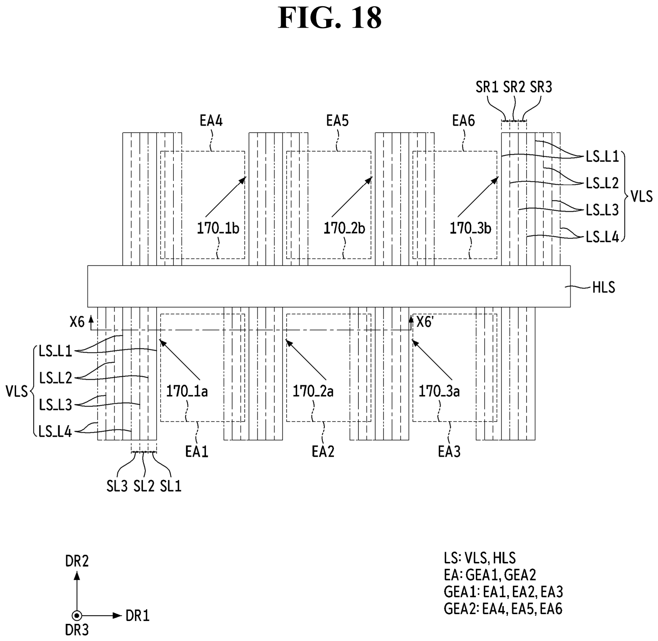

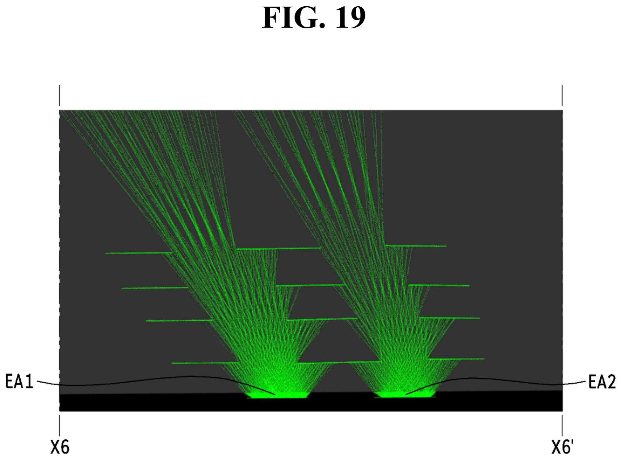

FIG. 18 is a plan view illustrating the planar arrangement of an emission area and a light control layer of a display device according to still another embodiment. FIG. 19 is a simulation photograph illustrating the movement path of light in a cross-section taken along line X6-X6' of FIG. 18.

Referring to FIGS. 18 and 19, the display device 10 according to the present embodiment is different from the display device 10 according to the embodiments described above with reference to FIGS. 7 and 13, and the like in that the arrangement directions of the first group area GEA1 and the second group area GEA2 are different.

More specifically, in the display device 10 according to the present embodiment, the first group area GEA1 and the second group area GEA2 may be located relative to each other in the second direction DR2. For example, the first to third emission areas EA1, EA2, and EA3 of the first group area GEA1 may be located in the first direction DR1, the fourth to sixth emission areas EA4, EA5, and EA6 of the second group area GEA2 may be located in the first direction DR1, but the first to third emission areas EA1, EA2, and EA3 and the fourth to sixth emission areas EA4, EA5, and EA6 may be located relative to each other in the second direction DR2.

The fourth emission area EA4 of the second group area GEA2 may be located on one side of the first emission area EA1 of the first group area GEA1 in the second direction DR2. The fifth emission area EA5 of the second group area GEA2 may be located on one side of the second emission area EA2 of the first group area GEA1 in the second direction DR2. The sixth emission area EA6 of the second group area GEA2 may be located on one side of the third emission area EA3 of the first group area GEA1 in the second direction DR2.

Light emitted from the first group area GEA1 located on the other side of the second direction DR2 may travel in the other direction of the first direction DR1, and light emitted from the second group area GEA2 located on one side of the second direction DR2 may travel in the one direction of the first direction DR1. However, the present disclosure is not limited thereto, the first group area GEA1 may be located on one side of the second direction DR2, the second group area GEA2 may be located on the other side of the second direction DR2, light emitted from the first group area GEA1 may travel in one direction of the first direction DR1, and light emitted from the second group area GEA2 may travel in the other direction of the first direction DR1.

The light blocking film LS may include a horizontal light blocking film HLS and a vertical light blocking film VLS.

The horizontal light blocking film HLS may be located between the first group area GEA1 and the second group area GEA2 in the second direction DR2. The horizontal light blocking film HLS may be extended in the first direction DR1. The horizontal light blocking film HLS may be located between the first group area GEA1 and the second group area GEA2 to prevent respective lights emitted from the first group area GEA1 and the second group area GEA2 from being mixed. The horizontal light blocking film HLS may be located in at least one of the first light blocking layer LS_L1, the second light blocking layer LS_L2, the third light blocking layer LS_L3, or the fourth light blocking layer LS_L4.

The vertical light blocking film VLS may be located on each of one side and the other side of the horizontal light blocking film HLS in the second direction DR2. The vertical light blocking film VLS may be extended in the second direction DR2. The vertical light blocking film VLS may be located between the first to third emission areas EA1, EA2, and EA3 of the first group area GEA1 and located between the fourth to sixth emission areas EA4, EA5, and EA6 of the second group area GEA2.

The vertical light blocking film VLS may include a first light blocking pattern located in the first light blocking layer LS_L1, a second light blocking pattern located in the second light blocking layer LS_L2, a third light blocking pattern located in the third light blocking layer LS_L3, and a fourth light blocking pattern located in the fourth light blocking layer LS_L4.

The first light blocking patterns of the vertical light blocking film VLS may be located not to overlap the emission areas EA. The second to fourth light blocking patterns of the vertical light blocking film VLS may be located to be shifted in the first direction DR1 relative to the first light blocking pattern. The second to fourth light blocking patterns of the vertical light blocking film VLS may be shifted to an increasing degree as they go toward the upper layers.

First, the vertical light blocking film VLS corresponding to the first group area GEA1 is described.

The first light blocking patterns of the vertical light blocking film VLS corresponding to the first group area GEA1 may not overlap the first to third emission areas EA1, EA2, and EA3. In the first direction DR1, the first light blocking pattern, the first emission area EA1, the first light blocking pattern, the second emission area EA2, the first light blocking pattern, the third emission area EA3, and the first light blocking pattern may be located in that order.

The second light blocking patterns of the vertical light blocking film VLS corresponding to the first group area GEA1 may be located to be shifted by a first shift distance SL1 toward the other side of the first direction DR1 relative to the first light blocking patterns. The third light blocking patterns of the vertical light blocking film VLS corresponding to the first group area GEA1 may be located to be shifted by a second shift distance SL2 toward the other side of the first direction DR1 relative to the second light blocking patterns. The fourth light blocking patterns of the vertical light blocking film VLS corresponding to the first group area GEA1 may be located to be shifted by a third shift distance SL3 toward the other side of the first direction DR1 relative to the third light blocking patterns.

In some embodiments, the second light blocking patterns, the third light blocking patterns, and the fourth light blocking patterns of the vertical light blocking film VLS corresponding to the first group area GEA1 may overlap the first to third emission areas EA1, EA2, and EA3. The overlapping area may be increased in the order of the fourth light blocking pattern, the third light blocking pattern, and the second light blocking pattern.

Likewise, the vertical light blocking film VLS corresponding to the second group area GEA2 is described.

The first light blocking patterns of the vertical light blocking film VLS corresponding to the second group area GEA2 may not overlap the fourth to sixth emission areas EA4, EA5, and EA6. In the first direction DR1, the first light blocking pattern, the first emission area EA1, the first light blocking pattern, the second emission area EA2, the first light blocking pattern, the third emission area EA3, and the first light blocking pattern may be located in that order.

The second light blocking patterns of the vertical light blocking film VLS corresponding to the second group area GEA2 may be located to be shifted by a fourth shift distance SR1 toward one side of the first direction DR1 relative to the first light blocking patterns. The third light blocking patterns of the vertical light blocking film VLS corresponding to the second group area GEA2 may be located to be shifted by a fifth shift distance SR2 toward one side of the first direction DR1 relative to the second light blocking patterns. The fourth light blocking patterns of the vertical light blocking film VLS corresponding to the second group area GEA2 may be located to be shifted by a sixth shift distance SR3 toward one side of the first direction DR1 relative to the third light blocking patterns.

In some embodiments, the second light blocking patterns, the third light blocking patterns, and the fourth light blocking patterns of the vertical light blocking film VLS corresponding to the second group area GEA2 may overlap the fourth to sixth emission areas EA4, EA5, and EA6. The overlapping area may be increased in the order of the fourth light blocking pattern, the third light blocking pattern, and the second light blocking pattern.

In some embodiments, the fourth shift distance SR1 may be substantially equal to the first shift distance SL1, the fifth shift distance SR2 may be substantially equal to the second shift distance SL2, and the sixth shift distance SR3 may be substantially equal to the third shift distance SL3.

According to the display device 10 according to the present embodiment, as illustrated in FIG. 19, lights emitted from the emission areas EA adjacent in the first direction DR1 may travel in the same direction. Lights emitted from the emission areas EA adjacent in the second direction DR2 may travel in different directions, as illustrated in FIG. 10.

The display device 10 according to one embodiment described with reference to FIG. 7 and the like may be referred to as a horizontal split display device, and the display device 10 according to still another embodiment described with reference to FIG. 18 and the like may be referred to as a vertical split display device.

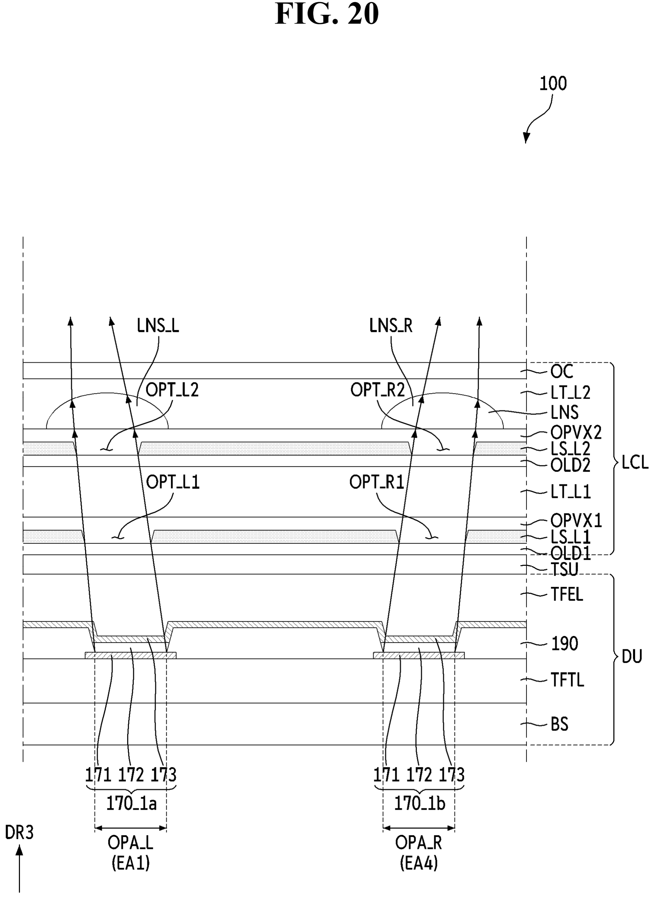

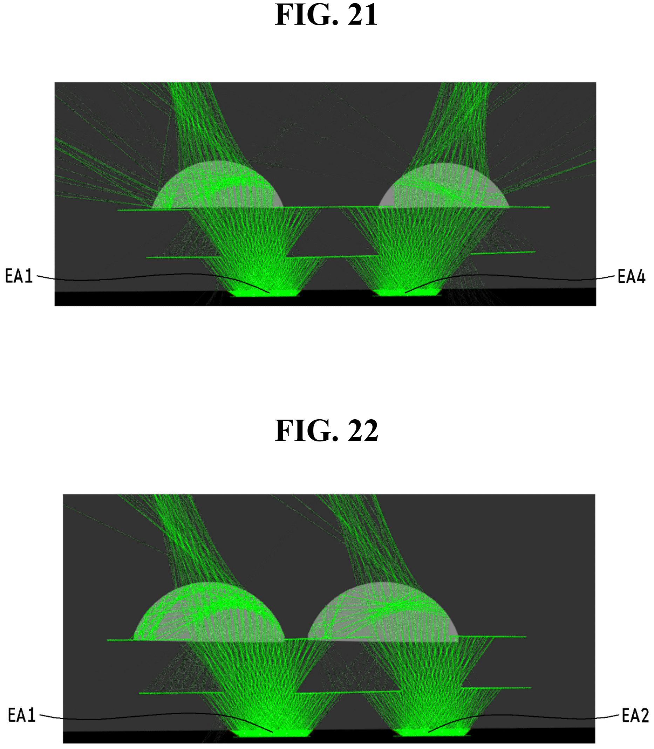

FIG. 20 is a cross-sectional view showing a cross-section of a display device according to still another embodiment. FIG. 21 is a simulation photograph illustrating the movement path of light in a horizontal split display device among the display devices according to the embodiment of FIG. 20. FIG. 22 is a simulation photograph illustrating the movement path of light in a vertical split display device among the display devices according to the embodiment of FIG. 20.

Referring to FIGS. 20 to 22, the display device 10 according to the present embodiment is different from the display device 10 according to the embodiments described above with reference to FIGS. 7, 13, and 20 in that an optical layer LNS is further included.

More specifically, the light control layer LCL according to the present embodiment may further include the optical layer LNS. The optical layer LNS may be located between the second light transmitting lower film OPVX2 and the second light transmitting film LT_L2. In another embodiment, the optical layer LNS may be located between the first light transmitting lower film OPVX1 and the first light transmitting film LT_L1. In still another embodiment, the optical layer LNS may be located between the second light blocking layer LS_L2 and the second light transmitting lower film OPVX2 or between the first light blocking layer LS_L1 and the first light transmitting lower film OPVX1.

The optical layer LNS may include a plurality of optical patterns. The plurality of optical patterns may include a first optical pattern LNS_L and a second optical pattern LNS_R. The plurality of optical patterns may overlap the first layer opening and the second layer opening in the third direction DR3. For example, the first optical pattern LNS_L corresponding to the first emission area EA1 may overlap the first sub-opening OPT_L1 and the third sub-opening OPT_L2 in the third direction DR3, and the second optical pattern LNS_R corresponding to the fourth emission area EA4 may overlap the second sub-opening OPT_R1 and the fourth sub-opening OPT_R2 in the third direction DR3.

In some embodiments, the width of the first optical pattern LNS_L may be greater than each of the widths of the first sub-opening OPT_L1 and the third sub-opening OPT_L2, and the width of the second optical pattern LNS_R may be greater than each of the widths of the second sub-opening OPT_R1 and the fourth sub-opening OPT_R2.

The plurality of optical patterns may include a condensing lens. The first optical pattern LNS_L and the second optical pattern LNS_R may include a condensing lens. For example, the first optical pattern LNS_L and the second optical pattern LNS_R may include convex lenses that are convex toward the display surface. The display surface is the surface opposite to the surface on which the light emitting layer 172 is located with respect to the optical layer LNS, and means the surface adjacent to the overcoat layer OC. In some embodiments, the plurality of optical patterns of the optical layer LNS may include at least one of a lenticular lens array or a microlens array.

In some embodiments, the refractive index of the optical layer LNS may be greater than the refractive indices of the first light transmitting film LT_L1 and the second light transmitting film LT_L2. For example, the difference between the refractive index of the optical layer LNS and the refractive indices of the first light transmitting film LT_L1 and the second light transmitting film LT_L2 may be approximately 0.15 or more. In the present disclosure, the refractive index refers to an absolute refractive index for the D-line (λ = 589 nm, yellow) of sodium (Na), and may be an absolute refractive index measured with respect to a wavelength of 589 nm, for example, using a refractive index meter (e.g., M-2000 ellipsometer, J.A. Woollam Co., Inc.) under a temperature of 25°C and a relative humidity of 50% according to the Cauchy Film Model, for example.

FIG. 21 illustrates the path of light in a horizontal split display device such as the display device illustrated in FIG. 10, and FIG. 22 illustrates the path of light in a vertical split display device such as the display device illustrated in FIG. 19.

The display device 10 according to the embodiment of FIGS. 21 and 22 includes a less number of light blocking layers than the display device 10 according to the embodiment of FIGS. 10 and 19, but may easily control the traveling path of light by the optical layer LNS.

That is, the display device 10 according to the present embodiment may more easily control the viewing angle of light emitted from the emission area EA by further including the optical layer LNS. Accordingly, the number of light blocking layers of the light blocking film LS may be reduced, so that the thickness of the display device 10 may be reduced, and process cost and efficiency may be increased.

The display device 10 according to the above-described embodiments may be applied to various electronic devices 1. An electronic device 1 according to one embodiment may include the above-described display device 10, and may further include, in addition to the display device 10, a module or device having other additional functions.

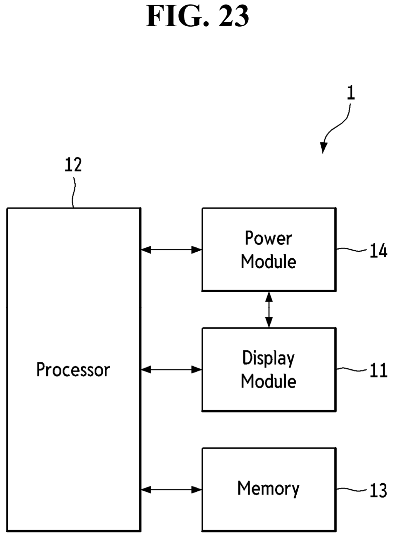

FIG. 23 is a block diagram of an electronic device according to one embodiment.

Referring to FIG. 23, the electronic device 1 according to one embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data information required for the operation of the processor 12 or the display module 11. When the processor 12 executes an application stored in the memory 13, an image data signal and/or an input control signal is transmitted to the display module 11, and the display module 11 may process the received signal and output image information through a display screen.

The power module 14 may include a power supply module, such as a power adapter or a battery device, and a power conversion module that converts power supplied by the power supply module to generate power required for the operation of the electronic device 1.

At least one of the components of the electronic device 1 described above may be included in the display device 10 according to the embodiments described above. Further, some of individual modules functionally included in one module may be included in the display device 10 and some others may be provided separately from the display device 10. For example, the display device 10 may include the display module 11, and the processor 12, the memory 13, and the power module 14 may be provided in the form of other devices in the electronic device 1 other than the display device 10.

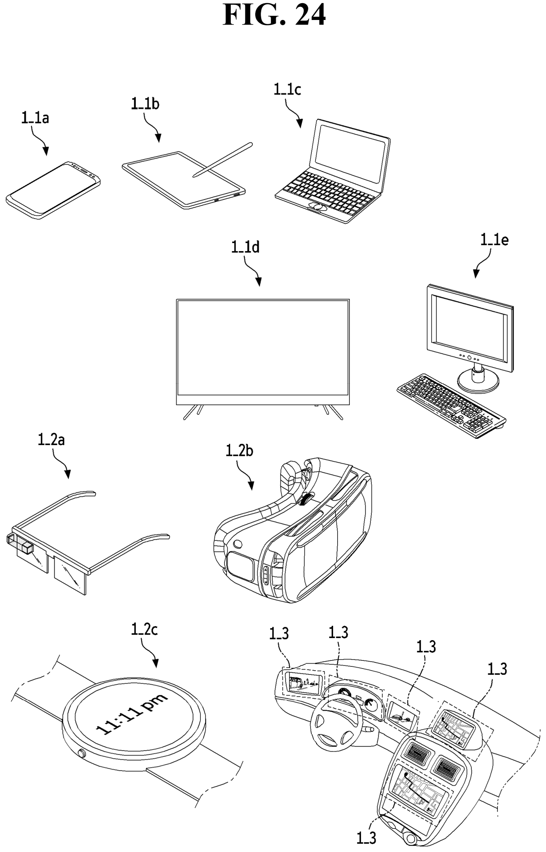

FIG. 24 is schematic views of electronic devices according to various embodiments. Referring to FIG. 24, various electronic devices to which the display device 10 according to embodiments is applied may include not only an image display electronic device such as a smartphone 1_1a, a tablet PC 1_1b, a laptop 1_1c, a TV 1_1d, and a desk monitor 1_1e, but also a wearable electronic device including a display module, such as smart glasses 1_2a, a head mounted display 1_2b, a smart watch 1_2c, or the like, a vehicle electronic device 1_3 including a display module, such as a center fascia, and a dashboard of an automobile, a center information display (CID) placed on the dashboard, a room mirror display, and the like.

## Claims

1. A display device (10) comprising:
a first emission area (EA1) and a second emission area (EA4);
a substrate (SUB1);
a circuit layer located on the substrate (SUB1);
an element layer (EML) located on the circuit layer, the element layer (EML) comprising a pixel defining film (190) defining a first opening (OPA_L) partitioning the first emission area (EA1) and a second opening (OPA_R) partitioning the second emission area (EA4), a first light emitting element (170_1a) located in the first opening (OPA_L), and a second light emitting element (170_1b) located in the second opening (OPA_R); and
a light control layer (LCL) located on the element layer (EML), the light control layer (LCL) comprising a first light blocking layer (LS_L1), a first light transmitting film (LT_L1), and a second light blocking layer (LS_L2),
wherein the first light blocking layer (LS_L1) comprises a first sub-opening (OPT_L1) corresponding to the first opening (OPA_L), and a second sub-opening (OPT_R1) corresponding to the second opening (OPA_R),
wherein the second light blocking layer (LS_L2) comprises a third sub-opening (OPT_L2) corresponding to the first opening (OPA_L), and a fourth sub-opening (OPT_R2) corresponding to the second opening (OPA_R),
wherein the first opening (OPA_L), the first sub-opening (OPT_L1), and the third sub-opening (OPT_L2) are arranged one after the other in a direction inclined with respect to a thickness direction (DR3) of the substrate (SUB1), and
wherein the second opening (OPA_R), the second sub-opening (OPT_R1), and the fourth sub-opening (OPT_R2) are arranged one after the other in another direction inclined differently than the direction with respect to the thickness direction (DR3).

2. The display device (10) of claim 1, wherein a first straight line (L1) connecting a center of the first sub-opening (OPT_L1) to a center of the third sub-opening (OPT_L2) is inclined away from the first side, and
a second straight line (L2) connecting a center of the second sub-opening (OPT_R1) to a center of the fourth sub-opening (OPT_R2) is inclined away from the second side.

3. The display device (10) of claim 2, wherein an absolute value of an inclination of the first straight line (L1) with respect to the thickness direction (DR3) is equal to an absolute value of an inclination of the second straight line (L2) with respect to the thickness direction (DR3).

4. The display device (10) of claim 2 or 3, wherein a third straight line (L3) connecting an edge section of the first sub-opening (OPT_L1) to an edge section of the third sub-opening (OPT_L2) is inclined away from the first side, and
a fourth straight line (L5) connecting an edge section of the second sub-opening (OPT_R1) to an edge section of the fourth sub-opening (OPT_R2) is inclined away from the second side.

5. The display device (10) of claim 4, wherein an absolute value of an inclination of the third straight line (L3) with respect to the thickness direction (DR3) is equal to an absolute value of an inclination of the fourth straight line (L5) with respect to the thickness direction (DR3).

6. The display device (10) of claim 4 or 5, wherein a fifth straight line (L4) connecting the opposite edge section of the first sub-opening (OPT_L1) to the opposite edge section of the third sub-opening (OPT_L3) is inclined away from the first side, and
a sixth straight line (L6) connecting the opposite edge section of the second sub-opening (OPT_R1) to the opposite edge section of the fourth sub-opening (OPT_R3) is inclined away from the second side.

7. The display device (10) of claim 6, wherein an absolute value of an inclination of the fifth straight line (L4) with respect to the thickness direction (DR3) is equal to an absolute value of an inclination of the sixth straight line (L6) with respect to the thickness direction (DR3), and/or
wherein an inclination of the first straight line (L1) with respect to the thickness direction (DR3) is smaller than an inclination of the third straight line (L3) with respect to the thickness direction (DR3), and greater than an inclination of the fifth straight line (L4) with respect to the thickness direction (DR3).

8. The display device (10) of any of claims 1 to 7, wherein a width of the first sub-opening (OPT_L1) is greater than a width of the third sub-opening (OPT_L2) and/or is equal to a width of the second sub-opening (OPT_R1), and/or
wherein a width of the second sub-opening (OPT_R1) is greater than a width of the fourth sub-opening (OPT_R2), and/or
wherein a width of the third sub-opening (OPT_2) and a width of the second sub-opening (OPT_R2) are equal to each other.

9. The display device (10) of any of claims 1 to 8, wherein each of the first light blocking layer (LS_L1) and the second light blocking layer (LS_L2) comprises:
a central light blocking film (LS_C) located between the first emission area (EA1) and the second emission area (EA4);
a first peripheral light blocking film (LS_L) located on a first side of the first emission area (EA1); and
a second peripheral light blocking film (LS_R) located on a first side of the second emission area (EA4),
wherein the first peripheral light blocking film (LSL_L), the first emission area (EA1), the central light blocking film (LS_C), the second emission area (EA4), and the second peripheral light blocking film (LS_R) are sequentially arranged perpendicular to the thickness direction (DR3).

10. The display device (10) of claim 9, wherein the central light blocking film (LS_C) of each of the first light blocking layer (LS_L1) and the second light blocking layer (LS_L2) at least partially overlaps the first emission area (EA1) and the second emission area (EA4), and
the first peripheral light blocking film (LS_L) and the second peripheral light blocking film (LS_R) of each of the first light blocking layer (LS_L1) and the second light blocking layer (LS_L2) do not overlap the first emission area (EA1) and the second emission area (EA4).

11. The display device (10) of any of claims 1 to 10, further comprising a third emission area (EA2) ,
wherein the pixel defining film (190) further comprises a third opening partitioning the third emission area (EA2),
the element layer (EML) further comprises a third light emitting element (170_2a) located in the third opening,
the first light blocking layer (LS_L1) further comprises a fifth sub-opening corresponding to the third opening,
the second light blocking layer (LS_L2) further comprises a sixth sub-opening corresponding to the third opening, and
the third opening, the fifth sub-opening, and the sixth sub-opening are arranged one after the other in the direction.

12. The display device (10) of claim 11, wherein the first emission area (EA1), the second emission area (EA4), and the third emission area (EA2) are sequentially arranged side by side in a first direction (DR1) crossing the thickness direction (DR3), and/or
wherein the first emission area (EA1) and the third emission area (EA2) are arranged side by side in a first direction (DR1) crossing the thickness direction (DR3), and
the first emission area (EA1) and the second emission area (EA4) extend in a second direction (DR2) crossing the thickness direction (DR3) and the first direction (DR1).

13. The display device (10) of any of claims 1 to 12, wherein the light control layer (LCL) further comprises an optical layer (LNS) located above the first light blocking layer (LSL_1) or the second light blocking layer (LSL_2),
the optical layer (LNS) comprises a first optical pattern (LNS_L) overlapping the first sub-opening (OPT_L1) and the third sub-opening (OPT_L2), and a second optical pattern (LNS_R) overlapping the second sub-opening (OPT_R1) and the fourth sub-opening (OPT_R2), and
the first optical pattern (LNS_L) and the second optical pattern (LNS_R) respectively comprise a condensing lens.

14. The display device (10) of claim 13, wherein the first optical pattern (LNS_L) and the second optical pattern (LNS_R) are convex in a direction opposite to the thickness direction (DR3), and/or
wherein a width of the first optical pattern (LNS_L) is greater than a width of the first sub-opening (OPT_L1) and a width of the third sub-opening (OPT_L2), and
a width of the second optical pattern (LNS_R) is greater than a width of the second sub-opening (OPT_R1) and a width of the fourth sub-opening (OPT_R2).

15. An automobile comprising:
a vehicle body;
an interior space defined by the vehicle body;
a dashboard located within the interior space; and
a display device (10) according to any of the previous claims and located on the dashboard.
